(19) Europäisches Patentamt
European Patent Office
Office européen des brevets

(11) **EP 2 815 421 B1**

(12) **EUROPÄISCHE PATENTSCHRIFT**

(45) Veröffentlichungstag und Bekanntmachung des Hinweises auf die Patenterteilung:
**31.01.2018 Patentblatt 2018/05**

(21) Anmeldenummer: **13712741.1**

(22) Anmeldetag: **21.03.2013**

(51) Int Cl.:
**C30B 29/40** (2006.01)     **H01L 21/02** (2006.01)
**C30B 25/10** (2006.01)     **C30B 25/16** (2006.01)
**C30B 25/18** (2006.01)

(86) Internationale Anmeldenummer:
**PCT/EP2013/055892**

(87) Internationale Veröffentlichungsnummer:
**WO 2013/139888 (26.09.2013 Gazette 2013/39)**

(54) **VERFAHREN ZUR HERSTELLUNG VON III-N-TEMPLATEN UND DEREN WEITERVERARBEITUNG, UND III-N-TEMPLATE**

METHOD FOR PRODUCING III-N TEMPLATES AND THE REPROCESSING THEREOF AND III-N TEMPLATE

PROCÉDÉ DE PRODUCTION DE MATRICES DE III-N ET LEUR TRAITEMENT ULTÉRIEUR ET MATRICES DE III-N

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.03.2012 DE 102012204553**
**21.03.2012 DE 102012204551**
**22.03.2012 US 201261614161 P**
**22.03.2012 US 201261614190 P**

(43) Veröffentlichungstag der Anmeldung:
**24.12.2014 Patentblatt 2014/52**

(73) Patentinhaber: **Freiberger Compound Materials GmbH**
**09599 Freiberg (DE)**

(72) Erfinder:
• **LIPSKI, Frank**
**72762 Reutlingen (DE)**
• **SCHOLZ, Ferdinand**
**89075 Ulm (DE)**
• **KLEIN, Martin**
**89077 Ulm (DE)**
• **HABEL, Frank**
**09599 Freiberg (DE)**

(74) Vertreter: **Prüfer & Partner mbB**
**Patentanwälte · Rechtsanwälte**
**Sohnckestraße 12**
**81479 München (DE)**

(56) Entgegenhaltungen:
EP-A1- 1 501 117          WO-A1-2007/068756
DE-A1-102005 041 643      US-A1- 2003 232 457
US-A1- 2006 046 325

• **KROST A ET AL: "In situ monitoring of the stress evolution in growing group-III-nitride layers", JOURNAL OF CRYSTAL GROWTH, ELSEVIER, AMSTERDAM, NL, Bd. 275, Nr. 1-2, 15. Februar 2005 (2005-02-15), Seiten 209-216, XP027849522, ISSN: 0022-0248 [gefunden am 2005-02-15]**
• **O. Klein ET AL: "TEM investigations on growth interrupted samples for the correlation of the dislocation propagation and growth mode variations in AlGaN deposited on SiNx interlayers", Journal of Crystal Growth, vol. 324, no. 1, 1 June 2011 (2011-06-01), pages 63-72, XP055013447, ISSN: 0022-0248, DOI: 10.1016/j.jcrysgro.2011.03.050**
• **KROST A ET AL: "Strain evaluation in AlInN/GaN Bragg mirrors by in situ curvature measurements and ex situ x-ray grazing incidence and transmission scattering", APPLIED PHYSICS LETTERS, A I P PUBLISHING LLC, US, vol. 97, no. 18, 3 November 2010 (2010-11-03), pages 181105-181105, XP012137485, ISSN: 0003-6951, DOI: 10.1063/1.3514241**

EP 2 815 421 B1

**Beschreibung**

Die vorliegende Erfindung betrifft Verfahren zur Herstellung von Verbundsubstraten (im Folgenden "Templat(e)" genannt) und zur Herstellung von III-N-Einkristallen. Die erfindungsgemäßen Verfahren ermöglichen die Herstellung von rissfreien III-N-Einkristallen, die insbesondere für die Verwendung als Wafer geeignet sind. III bedeutet mindestens ein Element der dritten Hauptgruppe des Periodensystems, ausgewählt aus der Gruppe von Al, Ga und In.

III-N-Einkristalle sind von großer technischer Bedeutung. Auf diesen Materialien beruhen eine Vielzahl von Halbleiterbauelementen und optisch-elektrischer Bauelemente wie Leistungsbauelemente, Hochfrequenzbauelemente, lichtemittierende Dioden und Laser. Bei der Herstellung solcher Vorrichtungen wird häufig epitaxiales Kristallwachstum auf einem Startsubstrat durchgeführt, oder es wird auf einem Startsubstrat zunächst ein Templat gebildet, worauf nachfolgend durch weiteres epitaxiales Wachstum III-N-Schichten bzw. -Einkristallkörper abgeschieden werden können. Als Startsubstrate können III-N-Substrate oder insbesondere Fremdsubstrate verwendet werden. Bei Verwendung von Fremdsubstraten kann es während des Wachstums aufgrund der Unterschiede der thermischen Ausdehnungskoeffizienten von Startsubstrat und aufgewachsener Schicht zu Verspannungen und Rissen innerhalb einer III-N-Schicht kommen. Dickere Schichten können auch unter Zuhilfenahme von zum Teil strukturierten, in einem externen Verfahren aufgebrachten Zwischenschichten aus WSiN, TiN oder SiO$_2$ gewachsen werden und im Anschluss als freistehende Schichten abgelöst werden, die typischerweise plastische, konkav verbogene c-Gitterebenen und Oberflächen aufweisen. An und oberhalb der Grenzfläche zwischen Startsubstrat und aufgewachsener III-N-Schicht können vertikale und horizontale Mikrorisse entstehen, die sich mit der Zeit ausdehnen und zum Bruch der GaN-Schicht bei oder nach dem Abkühlungsprozess führen können.

Aus Untersuchungen von Hearne et al., Applied Physics Letters 74, 356-358 (1999) ist bekannt, dass während der Abscheidung von GaN auf Saphirsubstrat sich ein mit dem Wachstum zunehmender instrinsischer tensile Verspannung (Stress) aufbaut. Ein *in situ* Stress Monitoring ergab, dass die durch das Wachtum erzeugte tensile Verspannung sich nicht messbar durch Annealing oder Thermal Cycling relaxieren lässt. Das bedeutet unter anderem, dass eine am Wachstumsende der GaN-Schicht erhaltene Verspannung nach Abkühlen und Wiederaufheizen auf die gleiche (Wachstums-)Temperatur wieder den gleichen Wert annimmt. Bei Hearne et al. findet man auch eine Erläuterung der Hintergründe, Zusammenhänge und Beobachtungsmöglichkeiten von extrinstischer (nämlich durch unterschiedliche theremische Ausdehnungskoeffizienten zwischen Saphirsubstrat und GaN-Schicht generierter) und instrinsischer (nämlich durch Wachstum erzeugter) Verspannung (Stress).

Um bei Mehrschichtaufbauten von III-N-Schichten auf Fremdsubstraten der Erzeugung von Spannung, namentlich von tensiler Spannung, mit zunehmendem Wachstum der III-N-Schichtaufbauten entgegenzuwirken, werden in der US 2008/0217645 A1 folgende Maßnahmen unternommen: erstens wird auf einer Nukleationsschicht eine AlGaN-Gradientenschicht aufgebracht, und zweitens werden relaxierte GaAl(In)N-Zwischenschichten zwischen Nitridschichten eingebracht.

Ferner werden in der US 2008/0217645 A1, wenn nach mehreren Epitaxieschichten die Versetzungsdichte im epitaxialen Schichtaufbau übermäßig ansteigt, Maskenschichten mit zum Beispiel SiN-, MgN- und/oder BN-Maskenmaterial eingesetzt, um die Versetzungsdichte zu reduzieren.

Auch in weiteren Beispielen und anderen Zusammenhängen wird der Einfluss von Maskenschichten auf die Veränderung der Versetzungsdichte beschrieben, so etwa bei Tanaka et al., Jpn. J. Appl. Phys. Vol. 39, L831-L834 (2000) (insbesondere in Bezug auf die Verwendung eines SiC-Fremdsubstrats), in der WO2012035135A1 (insbesondere in Bezug auf die Verwendung eines Si-Fremdsubstrats) sowie bei der unten näher diskutierten Publikation von Hertkorn et al. (2008).

In Journal of Crystal Growth 289, 445-449 (2006) wird von Napierala et al. ein Verfahren zur Herstellung von GaN/Saphirtemplaten beschrieben, auf dem rissfreie dünne GaN-Schichten aufgewachsen werden, indem die intrinsische Verspannung im Galliumnitrid durch das Einstellen der Dichte von Galliumnitrid-Kristalliten kontrolliert werden kann, sodass Verspannungen in den dünnen Schichten durch Verbiegen freigesetzt werden können. Jedoch können dicke Schichten in diesem Verfahren den Druck während des Wachsens nicht kompensieren und neigen trotz der Verbiegung zu Brüchen. Richter et al. (E. Richter, U.Zeimer, S.Hagedorn, M.Wagner, F.Brunner, M.Weyers, G.Tränkle, Journal of Crystal Growth 312, [2010] 2537) beschreiben ein Verfahren zur Herstellung von GaN-Kristallen über Hydridgasphasenepitaxie (HVPE), bei dem GaN-Schichten von 2,6 mm rissfrei gewachsen werden können über die Einstellung des partiellen Galliumchloriddrucks, wobei die erhaltenen GaN-Schichten auf der Oberfläche eine Vielzahl von V-Pits aufweisen. Ein mit diesem Prozess gewachsener Kristall besitzt eine Dicke von 5,8 mm, allerdings weist er längere Risse auf. In Journal of Crystal Growth 298, 202-206 (2007) zeigen Brunner et al. den Einfluss der Schichtdicke auf die Krümmung der aufwachsenden III-N-Schicht auf. Es wird das Wachstum von GaN und AlGaN, ggf. mit InGaN-Komplianz-Schicht, auf GaN-Saphir-Templat untersucht. Dabei hat sich gezeigt, dass für GaN und AlGaN mit 2,8% und 7,6% Al-Molanteil die konkave Krümmung während des Wachstums zunimmt. Ferner nimmt die konkave Krümmung dabei mit aufsteigendem Aluminiumgehalt zu. Zusätzlich wird der Einfluss einer Si-dotierten Indium-Gallium-Nitridschicht auf das Wachstum einer AlGaN-Schicht mit 7,6% Al-Molanteil auf eine GaN-Pufferschicht gezeigt. Dazu wird einerseits eine AlGaN-Schicht mit 7,6% Al-Molanteil direkt auf eine GaN-Pufferschicht aufgewachsen und andererseits eine Si-dotierten Indium-Gallium-Nitridschicht als Zwischenschicht auf eine GaN-Pufferschicht, wobei im Anschluss eine AlGaN-Schicht mit 7,6% Al-Molanteil auf die Zwischenschicht aufgewachsen wird. So wurde gezeigt, dass das Auftragen einer Si-dotierten Indium-Gallium-Nitridschicht auf eine GaN-Pufferschicht zu kompressiver Verspannung in dem Kristall führt. Während dieses Verfahrens wird die zunächst konkave Krümmung der GaN-Pufferschicht im Zuge einer Temperaturabsenkung in eine leicht konvexe Krümmung überführt, und durch Aufwachsen einer $In_{0,06}Ga_{0,94}N$-Schicht innerhalb desselben Verfahrens nimmt diese konvexe Krümmung im weiteren Wachstum zu. Bei der anschließenden Auftragung einer $Al_{0,076}Ga_{0,924}N$-Schicht auf dieser $In_{0,06}Ga_{0,94}N$-Schicht wird schließlich eine konkave Krümmung erreicht, die vergleichsweise geringer ausfällt als die resultierende Krümmung ohne $In_{0,06}Ga_{0,94}N$-Zwischenschicht.

E. Richter, M. Gründer, B. Schineller, F. Brunner, U. Zeimer, C. Netzel, M. Weyers und G. Tränkle (Phys. Status Solidi C 8, No. 5 (2011) 1450) beschreiben ein Verfahren zur Herstellung von GaN-Kristallen mittels HVPE, wobei eine Dicke bis zu 6,3 mm erreicht werden kann. Diese Kristalle zeigen schräg geneigte Seitenwände und V-Pits auf der Oberfläche. Des Weiteren zeigt sich im Kristallgitter eine konkave Krümmung von ca. 5,4 m und eine Versetzungsdichte von $6x10^5$ cm$^{-2}$.

Hertkorn et al. beschreiben in J. Cryst. Growth 310 (2008), 4867-4870 Prozessbedingung zum Bilden von 2-3$\mu$m dünnen GaN-Schichten mittels metallorganischer Gasphasenepitaxie (MOVPE, *Metal-Organic Vapor Phase Epitaxy*) unter Verwendung von in situ abgeschiedenen $SiN_x$-Masken. In Bezug auf unterschiedliche Lagen bzw. Positionen der $SiN_x$-Masken, konkret bei 0 (d.h. direkt auf einer AlN-Nukleationsschicht) oder nach dem Wachsen von 15, 50, 100, 350 und 1000nm, wird der Zusammenhang mit einer möglichen Beeinflussung von Defekten bzw. dem Verlauf der Versetzungsdichte untersucht. Als Ergebnis wird vermutet, dass eine Defektterminierung bzw. Verminderung der Versetzungsdichte am effektivsten ist, wenn das $SiN_x$ nach dem Wachstum von 100nm GaN positioniert wird. Es wird aber andererseits als negativ und problematisch hervorgehoben, dass die $SiN_x$-Abscheidung direkt auf oder in der Nähe der AlN-Nukleationsschicht stark kompressiv verspannte GaN-Schichten erzeugte und zur Schichtmissbildung - sogenannter *stackingfaults (Stapelfehler),* die im Transmissionselektronenmikroskop sichtbar waren und ferner mit einer Verbreiterung der $D^0X$-Linienbreite und der Röntgenpeaks einherging - führte und daher zur Vermeidung solcher Probleme eine zweite $SiN_x$-Maske nach 1,5$\mu$m zur Abschirmung der Defekte abgeschieden wurde. Abgesehen von einer Reduzierung der Versetzungsdichte, die aber auch als mit nachteiligen Effekten assoziiert beschrieben war, haben die Autoren nicht erkannt, welche für die Weiterverwendung von Templaten wichtigen Parameter durch eine $SiN_x$-Abscheidung wie beeinflusst werden können, und vor allem ob und wie eine spätere Rissbildungsneigung beim Wachstum weiterer III-N-Schichten und -Massivkristalle unterdrückt werden kann.

DE 102006008929 A1 beschreibt ein Nitridhalbleiter-Bauelement auf Basis eines Siliciumsubstrats und dessen Herstellung, mit der Abscheidung einer aluminiumhaltigen Nitridankeimschicht auf dem Siliciumsubstrat. Es wird ein Verfahren beschrieben, das speziell auf der Anwendung eines Siliciumsubstrats beruht, wobei festgestellt wird, dass das Wachstum von Halbleiterschichten auf Saphir-Substraten völlig anderen Randbedingungen unterliegt als das Wachstum auf Siliciumsubstrat. In der Tat ist im Ergebnis die gemäß dem System der DE 102006008929 A1 gewachsene III-N Schicht nach Abkühlung auf Raumtemperatur nicht kompressiv, noch nicht einmal annähernd kompressiv verspannt, sondern lediglich weniger tensil verspannt als eine herkömmliche, auf Siliciumsubstrat gewachsene III-N Schicht.

US 2009/0092815 A1 beschreibt die Herstellung von Aluminiumnitridkristallen zwischen 1 und 2 mm Dicke sowie Aluminiumnitridschichten mit 5 mm Dicke. Diese Schichten werden als rissfrei beschrieben und können herangezogen werden, um farblose und optisch durchsichtige Wafer zu schneiden mit mehr als 90% nutzbarer Fläche für die Anwendung in der Bauteilherstellung oder Bauelementherstellung.

EP 1 501 117 A1 offenbart betrifft ein Verfahren zum Wachstum von versetzungs- und defektarmen GaN-Kristallen, wobei eine ELO (epitaxial lateral overgrowth)-Maske und eine sogenannte defectseeding-Maske aus Pt, Ni oder Ti zusammen verwendet werden. Insbesondere wird die Abscheidung einer ELO-Maske aus SiN oder SiO2 auf einem Saphir-Substrat mit anschließendem GaN-Wachstum beschrieben.

WO 2007/068756 A1 beschreibt ein Verfahren zur Herstellung von GaN mit geringer Versetzungsdichte. Insbesondere wird ein sogenanntes universal-lateral-overgrowth-Verfahren vorgestellt, das prinzipiell auch ohne Maske und nur durch Anpassung von 3D- und 2D-Wachstumsparametern zu einer Verringerung von threading-Versetzungen und verbiegungsarmen und rissfreien GaN-Schichten führt.

US 2003/0232457 A1 offenbart ein GaN-Templat, wobei eine AlGaN-Zwischenschicht zwischen einem Saphir-Substrat und einer GaN-Schicht verwendet wird und eine kompressive Verspannung eingestellt wird.

Klein et al., Journal of Crystal Growth 324, 63-72 (2011) beschreiben ein Verfahren zur Herstellung eines Templats, welches ein Saphir-Substrat und mindestens eine $Al_{0,2}Ga_{0,8}N$-Kristallschicht umfasst, wobei eine $SiN_x$-Zwischenschicht in einem Abstand gegenüber dem Fremdsubstrat bzw. der darauf gebildeten AlN-Nukleationsschicht 150 nm bzw. 170 nm aufgebracht wird; die $SiN_x$-Zwischenschicht hat den Zweck, die Versetzungsdichte zu reduzieren, um einen graduellen Übergang von der Saphir ($Al_2O_3$)-Gitterkonstante zur gewünschten abweichenden Gitterkonstante kontinuierlicher und spannungsangepasster zu erreichen.

Krost et al., Applied Physics Letter 97 (Nr. 18), 181105-181105 (2010) beschreiben ein Verfahren zur Herstellung eines Schichtaufbaus mit Nukleationsschicht, 130 nm AlGaN-Schicht, erste in situ-SiN-Maske, 1.6 $\mu$m GaN-Puffers-

chicht, 15 nm Niedertemperatur-AIN-Zwischenschicht, zweite in situ-SiN-Maske, 1.6 $\mu$m GaN-Pufferschicht sowie Bragg-Schichten. Damit dürfte der Abstand der ersten in situ-SiN-Maske gegenüber der auf dem Substrat gebildeten AIN-Nukleationsschicht 130 nm betragen.

Krost et al., (Journal of Crystal Growth 275 (2005), pp. 209-216) beschreibt die in situ Krümmungsmessung zur Bestimmung des Verspannungsverlaufs während des MOVPE-Wachstums von III-N-Schichten. Als Substrat wurde hauptsächlich Si verwendet.

Den Verfahren des vorbeschriebenen Stands der Technik ist gemein, dass nach Wachstum und Abkühlung III-N-Kristalle erhalten werden, die starker extrinsischer und intrinsischer Verspannung ausgesetzt sind, wodurch Risse oder andere Materialfehler entstehen können, die die Materialqualität und die Verarbeitbarkeit zu III-N-Substraten einschränken.

Daher war es Aufgabe der vorliegenden Erfindung, Herstellungsverfahren für Template und III-N-Kristalle bereitzustellen, die es ermöglichen, III-N-Kristalle unter Bedingungen zu wachsen, die den Einschluss von Materialfehlern minimiert und die Kristallqualität sowie die Verarbeitbarkeit verbessert.

Diese Aufgabe wird durch ein Verfahren gemäß Anspruch 1 gelöst. Weiterbildungen sind in den entsprechenden Unteransprüchen angegeben. Weiterhin stellt die Erfindung ein Verfahren gemäß Anspruch 10 sowie ein neues Templat gemäß Anspruch 11 bereit. Nützliche Verwendungen sind in den Ansprüchen 13 und 14 definiert.

Erfindungsgemäß wurden in einem Templat (d.h. einer Einheit mit Saphir umfassendem Fremdsubstrat und relativ dünner III-N-Kristallschicht, wobei eine solche Templat-Einheit ihrerseits als Ausgangsprodukt zur anschließenden Herstellung von III-N-Kristall-Boules/Ingots oder von III-N-Bauelementen fungiert) die richtige Beeinflussung der kritischen Parameter Krümmung und Verspannung des Templats jeweils alternativ als besonders wichtig erkannt für vorteilhafte Eigenschaften des Templats und dessen Weiterverwendung. Es wurde überraschend gefunden, dass diese Parameter durch sorgfältig ausgewählte Faktoren, welche insbesondere das Vorsehen und schichtweise Aufbringen eines Maskenmaterials je nach Position bzw. Schichtlage im Templat einschließt, sehr günstig beeinflusst werden können, wodurch vor allem einer späteren Rissbildung unter Verwendung des erfindungemäßen Templats wirksam entgegengewirkt werden kann. Zu den erfindungsgemäß relevanten und für die Weiterverwendung des Templats günstigen Einstellungen der Krümmung gehört es gemäß alternativer technischer Lösungen dafür zu sorgen, (i) dass eine später noch näher spezifizierte Krümmungsdifferenz ($K_a$-$K_e$) in mindestens einer Wachstumsphase bei der Templatherstellung auf den Bereich $\geq$ 0 und insbesondere >0 eingehalten wird, oder (ii) dass das hergestellte Templat im Zustand auf Wachstumstemperatur im wesentlichen nicht gekrümmt ist oder negativ (konvex) gekrümmt ist. Erfindungsgemäß können Template hergestellt werden, die unter epitaxialen Kristallwachstumsbedingungen keine oder annähernd keine Krümmung oder eine negative Krümmung und damit nur eine geringe intrinsische Spannung aufweisen, was sich als Ausgangssituation für die Weiterverarbeitung als vorteilhaft herausgestellt hat. Wie experimentell gezeigt ist es erfindungsgemäß möglich, dass die vorgenannten technischen Lösungen (i) und (ii) vorteilhaft ohne Einschluss von Dotierungen in die III-N-Schicht des Templats realisiert werden kann, d.h. dass abgesehen von den Komponenten für die Maskenmaterial-Zwischenschicht keine Fremdkomponenten im Templat vorgesehen sind ("fremd" im Sinne von anderen als die III- und N-Komponenten der III-N-Schicht). Weil erfindungsgemäß darauf geachtet werden kann, dass die Bildung der III-N-Schicht des Templats *in situ* mit der Bildung der Maskenmaterial-Zwischenschicht erfolgt, können außerdem die vorgenannten technischen Lösungen (i) und (ii) unabhängig von Oberflächenstrukturierungen des bereitgestellten Saphirsubstrats realisiert werden; letzteres betrifft nämlich lediglich herkömmliche, *ex situ* durchgeführte Musterungen, wie z.B. das Öffnen von Fenstern, das Bilden von Streifen oder Punkten und anderer Maskenstrukturen, etwa mittels (Photo-)Lithographie, herkömmliche Fälle also, in denen das erwünschte Krümmungsverhalten nicht wie gemäß der Erfindung eingestellt werden kann.

Im Fall von derart optional bereitgestellten Oberflächenstrukturierungen des Saphirsubstrats selbst, die gegebenenfalls Maskenmuster aufweisen können, wird erfindungsgemäß ferner darauf geachtet, zusätzlich Maskenmaterial als Zwischenschicht zumindest teilweise direkt auf dem Saphirsubstrat oder der gegebenenfalls vorhandenen III-N-Nukleationsschicht darauf (d.h. unmittelbar angrenzend), oder im kristallinen III-N-Material des Templats in einem passenden Abstand zu der Hauptoberfläche des Saphirsubstrats oder der gegebenenfalls vorhandenen III-N-Nukleationsschicht darauf (d.h. insoweit ein Kontakt zu Substrat bzw. III-N-Nukleationsschicht stattfindet) abzuscheiden, selbst wenn optional solche Oberflächenstrukturierungen auf dem Saphirsubstrat bereitgestellt werden. Außerdem sind die Dimensionen unterschiedlich: *ex situ* durchgeführte Oberflächenmaskierungen und -muster weisen typischerweise eine Dickendimension im $\mu$m-Bereich auf, wohingegen die erfindungsgemäß relevante *in situ* Maskenmaterial-Zwischenschicht typischerweise eine Dickendimension im sub-$\mu$m-Bereich aufweist.

Erfindungsgemäß ist es möglich, eine Spannung gezielt und falls gewünscht in einem bestimmten, für die Weiterverarbeitung günstigen Spannungswert quantitativ einzustellen; insbesondere kann erfindungsgemäß ein Templat in einen spannungsfreien, gegebenenfalls sogar kompressiv verspannten Bereich zu drehen. Dies kann in einer bevorzugten Ausführungsform allein durch das wie hier beschriebene passende Vorsehen einer Maskenmaterial-Zwischenschicht bewerkstelligt werden.

Das erfindungsgemäße Verfahren, und in verstärktem Maße die Beachtung der bevorzugten Merkmale des erfindungsgemäßen Verfahrens, erlaubt entsprechend eine vorteilhafte Einstellung der Verspannung in der III-N-Kristallschicht des Templats mit einem Wert $\varepsilon_{xx}$ bei Raumtemperatur (alternativ, oder zusätzlich auch, bei einer Wachstumstemperatur) von $\varepsilon_{xx} \leq 0$ und insbesondere von $\varepsilon_{xx} < 0$, und darüber hinaus noch von besonders passenden negativen $\varepsilon_{xx}$-Werten, was sich auf die erfindungsgemäße Weiterverwendung des Templats sehr günstig auswirkt und somit ein alternatives relevantes Produktmerkmal des erfindungsgemäßen Templats darstellt.

Herkömmliche und üblich durchgeführte einschlägige Verfahren haben bisher ein anderes Verhalten gezeigt oder die hier erkannten nützlichen Zusammenhänge nicht erkennen lassen. In herkömmlichen Verfahren unter Verwendung des Standard-Substrats Saphir zum Beispiel bildet sich typischerweise infolge unterschiedlicher thermischer Ausdehnungskoeffizienten von Fremdsubstrat und III-N-Schicht sowie weiterer Faktoren bei Wachstumstemperatur eine konkave Krümmung der Wachstumsoberfläche, die dann im Verlauf des weiteren Kristallwachstums, also mit zunehmender Dicke der III-N-Schicht, weiter ansteigt. Überraschend kann das erfindungsgemäße Verfahren so gestaltet werden, dass während einer bestimmten Wachstumsphase der III-N-Materialschicht des Templats eine gegebene Krümmung trotz des weiteren Wachstums der III-N-Materialschicht merklich abnimmt.

Ferner wird bei herkömmlichen Verfahren infolge einer stetig ansteigenden Krümmung eine entsprechend steigende intrinsische - typischerweise tensile - Spannung innerhalb des Kristalls aufgebaut, die gegebenenfalls bereits während des weiteren Wachstums und insbesondere bei Weiterverwendung bzw. -verarbeitung des Templats, spätestens bei Abkühlung von der epitaxialen Wachstumstemperatur, leicht zu Mikrorissen bis hin zu Brüchen führen kann. Demgegenüber kann beim Verfahren der vorliegenden Erfindung eine kontrolliert eingestellte intrinsische - typischerweise kompressive - Spannung beim epitaxialen Kristallwachstum gezielt gesteuert werden oder eine Krümmung auf Null oder nahezu Null eingestellt werden, so dass während des anschließenden Wachstums von III-N-Kristallen, z.B. zur Bildung von III-N-Massivkristallen - wahlweise während eines fortgesetzten Wachstums ohne Wachstumsunterbrechung, oder im Rahmen eines separaten Wachstumsprozesses mit Unterbrechung -, und sogar noch beim endgültigen Abkühlen Risse vermieden werden können.

In einem solchen III-N-Kristall wird ferner vermieden, dass Risse entstehen, die die Materialqualität und/oder die Verarbeitbarkeit zu III-N-Substraten einschränkt. "Rissfreier III-N-Kristall" gemäß der vorliegenden Erfindung bedeutet, dass er auf einer Fläche von 15 cm$^2$ bei Ansicht von jeweils 30 mm$^2$ Bildausschnitten mit einem optischen Mikroskop keinen Riss aufweist.

Gemäß der vorliegenden Erfindung kann ferner die mikroskopische Eigenschaft der Deformation $\varepsilon_{xx}$ der Gitterkonstante a beeinflusst werden. Die Deformation $\varepsilon$ wird in der Mechanik allgemein auch als Verzerrungstensor (*strain tensor*) bezeichnet, wobei $\varepsilon_{xx}$ dessen erste Komponente bedeutet.

Bei Kristallgittern ist die Deformation $\varepsilon_{xx}$ dabei folgendermaßen definiert:

$$\varepsilon_{xx} = \frac{\text{Gitterkonstante a} - \text{Gitterkonstante a}_0}{\text{Gitterkonstante a}_0}$$

wobei a die tatsächliche Gitterkonstante im Kristall und $a_0$ die theoretisch ideale Gitterkonstante darstellt, wobei für $a_0$ typischerweise ein Literatur-Wert von $a0 = 3.18926 \pm 0.00004$Å (nach V. Darakchieva, B. Monemar, A. Usui, M. Saenger, M. Schubert, Journal of Crystal Growth 310 (2008) 959-965) angenommen wird.

Demgemäß kann durch Aufwachsen von Kristallschichten unter extrinsischem Stress auf die tatsächlich vorliegenden Kristallgitterkonstanten Einfluss genommen werden. Beispielsweise kann durch extrinsischen Stress eine kompressive Spannung auf den wachsenden Kristall übertragen werden, wodurch Gitterkonstanten gegenüber Wachstum ohne Stress verkürzt werden. Dadurch baut sich innerhalb des Kristalls steuerbar und gezielt intrinsischer Stress auf, der die zuvor genannten Eigenschaften Deformation und Verspannung günstig beeinflusst.

Erfindungsgemäß ist es bevorzugt, dass III-N-Kristalle von Templaten der vorliegenden Erfindung einen $\varepsilon_{xx}$-Wert von $\leq$ 0, weiter bevorzugt von < 0 aufweisen. Solche Template eignen sich hervorragend als Ausgangsprodukte für das Aufwachsen weiterer epitaxialer Schichten des III-N-Systems, insbesondere zum Herstellen von dicken III-N-Schichten und -Boules (Massivkristalle).

Im Folgenden wird eine Zusammenstellung von Punkten angegeben werden, die Gegenstände, Weiterbildungen und besondere Merkmale der vorliegenden Offenbarung beschreiben:

1. Verfahren zur Herstellung eines Templats, welches ein Substrat und mindestens eine III-N-Kristallschicht umfasst, wobei III mindestens ein Element der dritten Hauptgruppe des Periodensystems, ausgewählt aus Al, Ga und In, bedeutet, wobei das Verfahren die Schritte Bereitstellen eines Substrats und

Wachstum eines kristallinen III-N-Materials auf dem Substrat

umfasst, wobei ein Maskenmaterial als Zwischenschicht auf dem Substrat, welches gegebenenfalls eine III-N-Nukleationsschicht aufweist, oder im kristallinen III-N-Material in einem Abstand vom Substrat oder der gegebenenfalls vorgesehenen III-N-Nukleationsschicht abgeschieden wird und danach das Wachstum eines kristallinen III-N-Materials erfolgt oder fortgesetzt wird, wobei der Abstand der Zwischenschicht des Maskenmaterials gegenüber dem Substrat bzw. der gegebenenfalls darauf gebildeten III-N-Nukleationsschicht maximal 50 nm beträgt, und wobei, wenn während des Kristallwachstums die Krümmung der Wachstumsoberfläche des III-N-Kristalls zu einem ersten, relativ früheren Zeitpunkt mit $K_a$ und zu einem zweiten relativ späteren Zeitpunkt mit $K_e$ bezeichnet wird, für eine Krümmungsdifferenz $(K_a-K_e) \geq 0$ gesorgt wird.

Bevorzugt ist der Bereich $K_a-K_e > 0$.

Das Substrat ist als Fremdsubstrat ausgebildet, d.h. ist ein gegenüber dem III-N-Material des Templats verschiedenes Material, insbesondere umfasst das Fremdsubstrat Saphir oder es besteht aus Saphir.

Das Maskenmaterial ist geeigneterweise als ein von Substratmaterial und III-N verschiedenes Material definiert, auf dem III-N-Wachstum gehemmt, gestört oder verhindert ist. Beispiele für das Maskenmaterial werden unten näher beschrieben.

Die Ausdrücke "relativ früh" und "relativ spät" bedeutet ein erster bzw. zweiter Zeitpunkt während des Kristallwachstums, der jeweils Anfang und Ende des gesamten Kristallwachstums der III-N-Kristallschicht sein kann, aber auch nur eine bestimmte Phase des gesamten Kristallwachstums der III-N-Kristallschicht definieren kann und es im letzten Fall nicht darauf ankommt, wie das Krümmungsverhalten vor dem ersten bzw. nach dem zweiten Zeitpunkt ist. Zum Beispiel, ohne aber darauf beschränkt zu sein, ist der relativ frühe erste Zeitpunkt gegeben durch den Zeitpunkt des Aufbringens der Zwischenschicht des Maskenmaterials, und zum Beispiel ist der relativ späte zweite Zeitpunkt gegeben durch das Ende der Herstellungsstufe des Templats, wiederum ohne darauf beschränkt zu sein. Den möglichen Varianten der jeweiligen Zeitpunkte gemeinsam ist eine jeweils günstige Beeinflussung von (Ver-)Spannung im gebildeten III-N-Kristall und/oder vom Krümmungsverhalten bzw. -zustand des Templats bei Wachstumstemperatur und/oder bei Raumtemperatur, jeweils im Vergleich zur Nichtbeachtung der genannten Beziehung $K_a-K_e$.

Der Ausdruck "Zwischenschicht" ist in weitem Sinne zu verstehen, in der Regel als eine Materiallage, die Maskenmaterial umfasst, gegebenenfalls neben Maskenmaterial noch weiteres Material wie etwa das III-N-Material umfasst oder materialfreie Lücken aufweist. Die Dicke der "Zwischenschicht" ist variabel, ist aber in der Regel dünn bis sehr dünn, geeigneterweise im Nanometer-Bereich (z.B. bis maximal 50 nm, vorzugsweise unter 5 nm) oder im Subnanometer-Bereich (z.B. bis unter 1 nm, insbesondere bis unter einer Monolage, d.h. 0,2 bis 0,3 nm oder weniger).

Abscheiden des Maskenmaterials der Zwischenschicht "auf dem Substrat" bedeutet direkt angrenzend an eine Oberfläche des Saphirs oder der optionalen III-N-Nukleationsschicht über dem Saphir (nicht erfindungsgemäß), und "in einem Abstand vom Substrat" bezeichnet den Abstand der Lage/Position der Maskenmaterial-Zwischenschicht von dieser Oberfläche.

2. Verfahren gemäß Punkt 1, dadurch gekennzeichnet, dass die Krümmungsdifferenz $(K_a-K_e)$ mindestens 5 km$^{-1}$, bevorzugt mindestens 10 km$^{-1}$, weiter bevorzugt mindestens 20 km$^{-1}$ und insbesondere mindestens 50 km$^{-1}$ beträgt.

3. Verfahren gemäß Punkt 1 oder 2, wobei das Templat weiterverwendet wird zum Aufbringen von einer oder mehreren weiteren III-N-Kristallschicht(en), wahlweise zum Herstellen eines III-N-Massivkristalls.

Weil das hergestellte Templat erfindungsgemäß durch Beachtung der Krümmungsdifferenz $K_a-K_e$ günstig beeinflusst wird ist das weitere Krümmungserhalten der Wachstumsoberfläche des III-N-Kristalls während eines sich optional anschließenden Aufbringens bzw. Aufwachsens weiteren Halbleitermaterials nicht festgelegt.

4. Verfahren zur Herstellung von III-N-Einkristall, wobei III mindestens ein Element der dritten Hauptgruppe des Periodensystems, ausgewählt aus Al, Ga und In, bedeutet, wobei das Verfahren die folgenden Schritte umfasst:

aa) Bereitstellen eines Templats, welches ein Saphir umfassendes Fremdsubstrat und eine III-N-Kristallschicht umfasst, wobei das Templat im Bereich einer Wachstumstemperatur nicht oder im wesentlichen nicht gekrümmt ist oder negativ gekrümmt ist, wobei im bereitgestellten Templat im Bereich über dem Fremdsubstrat oder in der III-N-Kristallschicht des Templats ein Maskenmaterial als Zwischenschicht so abgeschieden ist, dass ein Abstand der Zwischenschicht des Maskenmaterials gegenüber dem Substrat bzw. der gegebenenfalls darauf gebildeten III-N-Nukleationsschicht maximal 50 nm beträgt;

bb) Durchführen eines epitaxialen Kristallwachstums zum Bilden von weiterem III-N-Kristall auf dem Templat gemäß aa), wahlweise zum Herstellen von III-N-Massivkristall,

cc) optional Trennen von III-N-Einkristall oder III-N-Massivkristall und Fremdsubstrat. Erfindungsgemäß ist es bevorzugt, dass die erwünschte günstige Nichtkrümmung oder (kompressive oder konvexe) Negativkrümmung des Templats bei dessen Erhitzen im Anfangszustand, d.h. bevor das weitere Wachstums gemäß Schritt bb) erfolgt, durch gezielte Positionierung einer Zwischenschicht des Maskenmaterials in definierter und begrenzter Höhenlage auf/über dem Fremdsubstrat eingestellt wurde. Hierzu und zum Ausdruck "Zwischenschicht" s. die obigen Punkte 1 und 2.

Falls diese Maßnahme für die genannte Bedingung nicht oder nicht allein ausreicht, können zusätzlich weitere Parameter beachtet und eingestellt werden, zum Beispiel indem während einer begrenzten Phase des Wachstums der III-N-Schicht des Templats eine Variation der Wachstumstemperatur (Absenkung aufgrund der Wahl von Saphir als Fremdsubstrat) erfolgte und damit ein ergänzender und/oder alternativer Beitrag zu der Beziehung $K_a-K_e \geq 0$ geliefert wurde.

Der Ausdruck "Wachstumstemperatur" bezieht sich auf eine Temperatur, bei der eine Abscheidung, insbesondere ein epitaxiales Wachstum, eines gewünschten III-N-Kristall ermöglicht wird.

5. Verfahren gemäß einem der vorangehenden Punkte, dadurch gekennzeichnet, dass wenn für das Templat als Fremdsubstrat Saphir einer Dicke ($d_{Saphir}$) von ungefähr $430\,\mu m$ (d.h. $\pm 20\,\mu m$) und als III-N-Kristallschicht des GaN einer Dicke ($d_{GaN}$) von ungefähr $7\,\mu m$ (d.h. $\pm 0,5\,\mu m$) verwendet oder eingestellt wird,

beim III-N-Kristall eine Krümmung des Templats ($K_T$) an der Wachstumsoberfläche

(i) bei Wachstumstemperatur im Bereich von 0 bis -150 $km^{-1}$, bevorzugt im Bereich von -25 bis -75 $km^{-1}$ festgelegt wird, und/oder

(ii) bei Raumtemperatur im Bereich von <-200 $km^{-1}$, vorzugsweise -200 bis -400 $km^{-1}$, weiter bevorzugt im Bereich von -300 bis -350 $km^{-1}$ festgelegt wird;

wobei bei Verwendung oder Einstellung anderer Schichtdicken ($d_{Saphir}/d_{GaN}$) der Krümmungswert in Abhängigkeit der jeweiligen Schichtdicken analog der Stoney-Gleichung im folgenden Bereich liegt:

$$K_{T(dGaN;dSaphir)}=K_{T(7\mu m;430\mu m)}x(430\mu m/d_{Saphir})^2 x(d_{GaN}/7\mu m).$$

6. Verfahren gemäß einem der vorangehenden Punkte, dadurch gekennzeichnet, dass der III-N-Einkristall des Templats bei Raumtemperatur einen Krümmungsradius im Bereich von -2 bis -6 m aufweist.

7. Verfahren gemäß einem der vorangehenden Punkte, dadurch gekennzeichnet, dass im kristallinen III-N-Material eine kompressive Verspannung erzeugt wird.

Die kompressive Verspannung wird primär dadurch erzeugt, dass die Zwischenschicht des Maskenmaterials ohne Abstand bzw. bei einem gezielt festgelegten Abstand vom Saphir-Substrat bzw. der Nukleationsschicht abgeschieden wird.

8. Verfahren gemäß einem der vorangehenden Punkte, dadurch gekennzeichnet, dass der III-N-Einkristall des Templats bei Raumtemperatur eine kompressive Spannung von $\sigma_{xx}<-0,70$ GPa aufweist.

9. Verfahren gemäß einem der vorangehenden Punkte, dadurch gekennzeichnet, dass die Zwischenschicht des Maskenmaterials auf einer III-N-Nukleationsschicht auf dem Fremdsubstrat abgeschieden wird und anschließend das Wachstum des III-N-Kristalls durchgeführt wird. Bei dieser Ausführungsform ist es bevorzugt, dass die Zwischenschicht des Maskenmaterials direkt und unmittelbar auf der III-N-Nukleationsschicht des Fremdsubstrats abgeschieden wird, noch bevor die Koaleszenz beendet ist und danach das eigentliche Wachstum des III-N-Einkristalls des Templats einsetzt.

10. Verfahren gemäß einem der vorangehenden Punkte, dadurch gekennzeichnet, dass das Maskenmaterial bei der Herstellung des Templats auf dem Fremdsubstrat oder innerhalb der III-N-Schicht des Templats *in situ* in demselben Reaktor abgeschieden wird und/oder unmittelbar nach Abscheidung des Maskenmaterials mit dem III-N-Wachstumsprozess fortgesetzt wird.

11. Verfahren gemäß einem der vorangehenden Punkte, dadurch gekennzeichnet, dass das Maskenmaterial im Templat in einer Ebene gleichmäßig verteilt ist, bevorzugt aber diskontinuierlich abgeschieden ist.

Obgleich gemäß dieser möglichen Ausführungsformen das Maskenmaterial im Templat im Wesentlichen in einer Ebene vorliegt, kann die Form der Abscheidung unterschiedlich sein. Die Schicht des Maskenmaterials kann eine geschlossene Schicht bilden, alternativ und bevorzugt weist sie jedoch Unterbrechungen auf und ist diskontinuierlich in einer Schicht verteilt; sie kann insbesondere in Form von Netzstrukturen und/oder in Form von Nanoplättchen oder -inseln des Maskenmaterials vorliegen (Nano-Maske mit Maskenmaterial), wobei aus mikroskopischen oder nanodimensionierten Lücken in der diskontinuierlichen Maskenschicht heraus das nachfolgende Wachstum der III-N-Schicht nachfolgen kann. Auch die Dicke der Schicht des Maskenmaterials ist variabel. Den verschiedenen möglichen Abscheidungsformen ist eine jeweils günstige Beeinflussung von (Ver-)Spannung im gebildeten III-N-Kristall und/oder vom Krümmungsverhalten bzw. -zustand des Templats bei Wachstumstemperatur und/oder bei Raumtemperatur gemeinsam. Gewünschte Formen sind durch passende Parameter geeignet einstellbar, zum Beispiel durch Flussraten der entsprechenden Ausgangsmaterialien, durch Reaktordruck, durch Abscheidungstemperatur, oder durch Dauer der Abscheidung des Maskenmaterials.

12. Verfahren gemäß einem der vorangehenden Punkte, dadurch gekennzeichnet, dass keine zweite $SiN_x$-Maske im Abstand von $1,5\,\mu m$ abgeschieden wird, oder dass überhaupt keine zweite $SiN_x$-Maske abgeschieden wird.

13. Verfahren gemäß einem der vorangehenden Punkte, dadurch gekennzeichnet, dass im Templat nur eine einzige Schicht des Maskenmaterials abgeschieden wird.

14. Verfahren gemäß einem der vorangehenden Punkte, dadurch gekennzeichnet, dass das Maskenmaterial ein Material ist, auf dem eine III-N-Abscheidung gehemmt oder verhindert ist.

15. Verfahren gemäß dem vorangehenden Punkt, wobei das Maskenmaterial ausgewählt ist aus der Gruppe, die aus $Si_xN_y$ (worin x und y jeweils unabhängig voneinander positive Zahlen bedeuten, die zu stöchiometrischen oder unstöchiometrischen SiN-Verbindungen führen; insbesondere $Si_3N_4$), TiN, $Al_XO_Y$ (worin x und y jeweils unabhängig voneinander positive Zahlen bedeuten, die zu stöchiometrischen oder unstöchiometrischen AlO-Verbindungen führen; insbesondere $Al_2O_3$), $Si_XO_Y$ (worin x und y jeweils unabhängig voneinander positive Zahlen bedeuten, die zu stöchiometrischen oder unstöchiometrischen SiO-Verbindungen führen; insbesondere $SiO_2$), WSi, und WSiN besteht. Beim Abscheiden des Maskenmaterials wird vorzugsweise das Maskenmaterial direkt im Reaktor *in situ* aus entsprechenden reaktiven Spezies der jeweiligen Elemente aus der Gasphase abgeschieden, und vorzugsweise wird direkt danach die Abscheidung des eigentlichen III-N-Kristalls des Templats gestartet bzw. fortgesetzt.

16. Verfahren gemäß einem der vorangehenden Punkte, dadurch gekennzeichnet, dass das Fremdsubstrat aus Saphir besteht.

17. Verfahren gemäß einem der vorangehenden Punkte, dadurch gekennzeichnet, dass die Krümmung des III-N-Kristalls des Templats in mindestens einer Wachstumsphase durch Variieren der Wachstumstemperatur zusätzlich verändert wird.

18. Verfahren gemäß einem der vorangehenden Punkte, dadurch gekennzeichnet, dass in mindestens einer Abscheidungsphase des III-N-Kristalls des Templats das Wachstum bei einer gegenüber einer vorherigen III-N-Abscheidung abgesenkten Wachstumstemperatur erfolgt.

19. Verfahren gemäß Punkt 18, dadurch gekennzeichnet, dass die Temperaturabsenkung mindestens 10°C, vorzugsweise mindestens 20 °C beträgt, bevorzugt im Bereich von 20-50 °C, weiter bevorzugt im Bereich von 25-40 °C und besonders bevorzugt bei 30°C liegt.

20. Verfahren gemäß einem der vorangehenden Punkte, dadurch gekennzeichnet, dass das bereitgestellte Substrat eine polierte Oberfläche aufweist.

21. Verfahren gemäß einem der vorangehenden Punkte, dadurch gekennzeichnet, dass das bereitgestellte Substrat eine durch Lithographie oder nasschemisches Ätzen oder trockenchemisches Ätzen (z.B. ICP) strukturierte Oberfläche aufweist.

22. Verfahren gemäß einem der vorangehenden Punkte, dadurch gekennzeichnet, dass auf dem Templat oder auf dem darauf epitaxial aufgewachsenen III-N-Kristall mindestens eine und gegebenenfalls weitere GaN-, AlN-, AlGaN-, InN-, InGaN-, AlInN- oder AlInGaN-Schicht(en) zur Herstellung entsprechend weiterer III-N-Schichten oder III-N-Kristalle aufgebracht wird (werden).

23. Verfahren gemäß einem der vorangehenden Punkte, dadurch gekennzeichnet, dass die III-N-Kristallschicht des Templats sowie der darauf epitaxial aufgewachsene III-N-Kristall aus demselben III-N Material bestehen.

24. Verfahren gemäß einem der vorangehenden Punkte, dadurch gekennzeichnet, dass die III-N-Kristallschicht auf dem Fremdsubstrat sowie der darauf epitaxial aufgewachsene III-N-Kristall jeweils ein binäres System bilden.

25. Verfahren gemäß einem der vorangehenden Punkte, wobei nach Abscheiden der Zwischenschicht des Maskenmaterials *in situ* zusätzliches Kristallwachstum zum Bilden von III-N-Kristall mit einer Gesamtdicke im Bereich von 0,1-10 $\mu$m erfolgt, vorzugsweise mit einer Dicke im Bereich von 3 bis 10 $\mu$m, wodurch ein Templat erhalten wird, wobei die Gesamtdicke der III-N-Schicht des Templats einschließlich der Zwischenschicht des Maskenmaterials gerechnet wird.

26. Verfahren gemäß einem der vorangehenden Punkte, dadurch gekennzeichnet, dass MOVPE als Aufwachsmethode verwendet wird.

27. Verfahren gemäß einem der vorangehenden Punkte, dadurch gekennzeichnet, dass auf dem Templat III-N-Einkristalle gewachsen werden mit Schichtdicken von mindestens 1 mm, bevorzugt von mindestens 5 mm, mehr bevorzugt von mindestens 7 mm und am meisten bevorzugt von mindestens 1 cm.

28. Verfahren gemäß einem der vorangehenden Punkte, dadurch gekennzeichnet, dass das Kristallwachstum mindestens im Schritt nach Abschluss der Templatbildung, gegebenenfalls von Anfang an und in allen Kristallwachstumsschritten, mittels HVPE durchgeführt wird.

29. Verfahren zur Herstellung von III-N-Einkristall gemäß einem der vorangehenden Punkte, dadurch gekennzeichnet, dass nach Abschluss des Kristallwachstums der gewachsene III-N-Einkristall und das Saphir umfassende Fremdsubstrat durch Selbstablösung voneinander getrennt werden, vorzugsweise beim Abkühlen von einer Kristallwachstumstemperatur.

30. Verfahren zur Herstellung von III-N-Einkristall gemäß einem der vorangehenden Punkte, dadurch gekennzeichnet, dass nach Abschluss des Kristallwachstums der gewachsene III-N-Einkristall und das Saphir umfassende Fremdsubstrat durch Abschleifen, Absägen oder einen lift-off-Prozess voneinander getrennt werden.

31. Verfahren zur Herstellung von III-N-Kristallwafern, wobei III mindestens ein Element der dritten Hauptgruppe des Periodensystems ausgesucht aus der Gruppe von Al, Ga und In bedeutet, wobei das Verfahren die folgenden Schritte umfasst:

a) Durchführung eines Verfahrens gemäß einem der Punkte 3 bis 30 zum Bilden eines III-N-Massivkristalls, und
b) Vereinzeln des Massivkristalls zum Bilden von Wafern.

32. Templat mit einem Saphir umfassenden Substrat und mindestens einer III-N-Kristallschicht, wobei III mindestens ein Element der dritten Hauptgruppe des Periodensystems, ausgewählt aus der Gruppe von Al, Ga und In, bedeutet, wobei im Bereich über dem Fremdsubstrat oder in der III-N-Kristallschicht des Templats ein Maskenmaterial als Zwischenschicht vorgesehen ist, wobei in der III-N-Kristallschicht des Templats ein Wert $\varepsilon_{xx}$ bei Raumtemperatur von $\varepsilon_{xx} < 0$ eingestellt ist.

33. Templat mit einem Saphir umfassenden Substrat und mindestens einer III-N-Kristallschicht, wobei III mindestens ein Element der dritten Hauptgruppe des Periodensystems, ausgewählt aus der Gruppe von Al, Ga und In, bedeutet, wobei im Bereich über dem Fremdsubstrat oder in der III-N-Kristallschicht des Templats ein Maskenmaterial als Zwischenschicht vorgesehen ist, wobei in der III-N-Kristallschicht des Templats ein Wert $\varepsilon_{xx}$ bei Wachstumstemperatur von $\varepsilon_{xx} \leq 0$ eingestellt ist, wobei $\varepsilon_{xx}$ mit Hilfe einer Röntgenmessung der absoluten Gitterkonstante bestimmt ist, und wobei ein Abstand der Zwischenschicht des Maskenmaterials gegenüber dem Substrat bzw. der gegebenenfalls darauf gebildeten III-N-Nukleationsschicht maximal 50 nm beträgt.

34. Templat gemäß Punkt 32 oder 33, wobei in der III-N-Kristallschicht des Templats der Wert $\varepsilon_{xx}$ bei Raumtemperatur im Bereich $0 > \varepsilon_{xx} \geq -0{,}003$ und insbesondere im Bereich $-0{,}0015 > \varepsilon_{xx} \geq -0{,}0025$ und insbesondere im Bereich $-0{,}0020 \geq \varepsilon_{xx} \geq -0{,}0025$ eingestellt ist.

35. Templat gemäß einem der Punkte 32 bis 34, wobei in der III-N-Kristallschicht des Templats der Wert $\varepsilon_{xx}$ bei Wachstumstemperatur im Bereich von $0 > \varepsilon_{xx} > -0{,}0006$, bevorzugt im Bereich von $-0{,}0003 > \varepsilon_{xx} > -0{,}0006$ liegt.

36. Templat gemäß einem der Punkte 32 bis 35 in Form eines Templats mit einer Schichtdicke des III-N-Einkristalls im Bereich von 0,1-10 $\mu$m, bevorzugt von 2-5 $\mu$m, gerechnet inklusive Zwischenschicht des Maskenmaterials.

37. Templat gemäß einem der Punkte 32 bis 36, dadurch gekennzeichnet, dass der III-N-Einkristall bei Raumtemperatur eine kompressive Spannung von $\sigma_{xx} < -0{,}70$ GPa aufweist.

38. Templat gemäß einem der Punkte 32 bis 37, dadurch gekennzeichnet, dass wenn für das Templat als Fremdsubstrat Saphir einer Dicke ($d_{Saphir}$) von ungefähr 430$\mu$m (d.h. $\pm 20\mu$m) und als III-N-Kristallschicht des GaN einer Dicke ($d_{GaN}$) von ungefähr 7$\mu$m (d.h. $\pm 0{,}5\mu$m) verwendet oder eingestellt wird, beim III-N-Kristall eine Krümmung des Templats ($K_T$)

(i) bei Wachstumstemperatur im Bereich von 0 bis -150 km$^{-1}$, bevorzugt im Bereich von -25 bis -75 km$^{-1}$ festgelegt ist; und/oder
(ii) bei Raumtemperatur im Bereich von -200 bis -400 km$^{-1}$, bevorzugt im Bereich von -300 bis -400 km$^{-1}$, weiter bevorzugt im Bereich von -300 bis -350 km$^{-1}$ festgelegt ist,

wobei bei Verwendung oder Einstellung anderer Schichtdicken ($d_{Saphir}/d_{GaN}$) der Krümmungswert in Abhängigkeit der jeweiligen Schichtdicken analog der Stoney-Gleichung in folgenden Bereich liegt:

$$K_{T(dGaN;dSaphir)} = K_{T(7\mu m;430\mu m)} \mathrm{x}(430\mu m/d_{Saphir})^2 \mathrm{x}(d_{GaN}/7\mu m).$$

39. Templat gemäß einem der Punkte 32 bis 38, dadurch gekennzeichnet, dass III = Ga bedeutet und der Kristall in Wachstumsrichtung eine Gitterkonstante im Bereich von 0,31829 nm < a < 0,318926 nm aufweist.

40. Templat gemäß einem der Punkte 32 bis 39, dadurch gekennzeichnet, dass das Saphir umfassende Substrat entfernt ist.

41. Templat gemäß einem der Punkte 32 bis 40, hergestellt nach oder verwendet in einem der Verfahren gemäß den Punkte 1 bis 31.

42. Verwendung von nach Punkt 31 hergestellten III-N-Wafern, oder Verwendung eines Templats gemäß einem der Punkte 32 bis 41 zur Herstellung von dickeren III-N-Schichten oder III-N-Kristallboules bzw. -Massivkristallen, die optional danach in einzelne III-N-Wafer vereinzelt werden.

43. Verwendung von nach Punkt 31 hergestellten III-N-Wafern, oder Verwendung eines Templats gemäß einem der Punkte 32 bis 41, jeweils zur Herstellung von Halbleiterelementen, elektronischen oder optoelektronischen Bauelementen.

44. Verwendung gemäß Punkt 43 zur Herstellung von Leistungsbauelementen, Hochfrequenzbauelementen, lichtemittierenden Dioden und Lasern.

45. Verwendung eines Maskenmaterials als Zwischenschicht in einem Templat, welches ein Saphir umfassendes Substrat und eine III-N-Kristallschicht aufweist, wobei III mindestens ein Element der dritten Hauptgruppe des Periodensystems, ausgewählt aus der Gruppe von Al, Ga und In, bedeutet, zum Steuern eines Krümmungswerts und/oder einer Verspannung des Templats, um nach Einstellung eines bestimmten Krümmungswerts und/oder einer bestimmten Verspannung mindestens eine weitere III-N-Kristallschicht auf dem Substrat aufzubringen, wobei ein Abstand der Zwischenschicht des Maskenmaterials gegenüber dem Substrat bzw. der gegebenenfalls darauf gebildeten III-N-Nukleationsschicht vorliegt und maximal 50 nm beträgt.

46. Verwendung gemäß Punkt 45, wobei der bestimmte Krümmungswert und/oder die bestimmte Verspannung eine Rissbildung in einem anschließenden weiteren Wachstum einer zusätzlichen III-N-Schicht vermeidet.

Die in der Anmeldung genannten Temperaturen beziehen sich, soweit nichts anderes gesagt ist, auf die an Heizeinrichtungen entsprechend eingestellten Temperaturen, d.h. nominal eingestellten Temperaturen für jeweilige Schritte (Prozesstemperatur). Die Temperaturen am Templat/Wafer liegen typischerweise etwas tiefer, was je nach Reaktortyp verschieden sein kann; z.B. bis 75K tiefer. So liegen beim in den Beispielen verwendeten Reaktortyp die Temperaturen am Templat/Wafer (gemessen mit einem in-situ Messgerät EpiTT der Firma Laytec, Berlin, Deutschland) etwa 30-50K unter Prozesstemperatur.

KURZBESCHREIBUNG DER FIGUREN

| | |
|---|---|
| Fig. 1A und 1B | zeigen schematisch Stufen des Aufwachsprozesses zum Bilden von III-N-Templaten mit Saphirsubstrat, und mit jeweils unterschiedlichen Ausführungsformen gemäß der vorliegenden Erfindung; |
| Fig. 2 | veranschaulicht zeitliche Temperatur-, Reflexions- und Krümmungsverläufe beim beispielhaften Wachstum von GaN auf Saphir (Abstand 15 nm); |
| Fig. 3 | veranschaulicht zeitliche Temperatur-, Reflexions- und Krümmungsverläufe bei Wachstum von GaN auf Saphir (Abstand 300 nm); |
| Fig. 4 | zeigt die Veränderung der Krümmung der Wachstumsoberfläche gemäß einem anderen Prinzip, bei dem optional eine Abscheidung einer Zwischenschicht mit Maskenmaterial kombiniert wird mit einer Veränderung der III-N-Wachstumstemperatur während des Wachstums der III-N-Schicht des Templats; |
| Fig. 5A und 5B | zeigen die Veränderung der Krümmung der Wachstumsoberfläche hauptsächlich in Abhängigkeit von Vorsehen und Lage/Positionierung einer Zwischenschicht mit Maskenmaterial gemäß unterschiedlichen möglichen Ausführungsformen der vorliegenden Erfindung, |
| Fig. 5C | zeigt die Ergebnisse bezüglich Krümmung der Wachstumsoberfläche, wenn die gemäß Fig. 5A und 5B definierten Template einem weiteren III-N (GaN)-Schichtwachstum zur Herstellung dickerer Schichten unterzogen werden, und |
| Fig. 6 | veranschaulicht zeitliche Temperatur-, Reflexions- und Krümmungsverläufe bei herkömmlichem Wachstum von GaN auf Saphir. |

Ohne die vorliegende Erfindung damit einzuschränken, soll die nachfolgend detaillierte Beschreibung der Figuren, Gegenstände, Weiterbildungen und besondere Merkmale die Erfindung anschaulich darstellen und besondere Ausführungsformen detaillierter beschreiben.

Im Verfahren zur Herstellung von III-N-Startsubstraten wurde überraschenderweise gefunden, dass die Template wesentlich durch passende Positionierung einer Zwischenschicht von Maskenmaterial in Bezug auf die relevanten Parameter Krümmung der Wachstumsoberfläche am Templat und/oder geeignete Verspannung im Templat derart günstig beeinflusst werden können, dass das nachfolgende Wachstum von III-N-Einkristallen mit herausragenden Eigenschaften ermöglicht wird und insbesondere die nachfolgende Neigung zu Rissbildung in auf dem Templat wachsenden III-N-Einkristallen signifikant reduziert wird.

Für die Herstellung des Templats wird zunächst ein Substrat bereitgestellt, welches ausgewählt wird aus Saphir umfassenden bzw. aus Saphir bestehenden Startsubstraten sowie solchen Ausgangssubstraten mit darauf gebildeten Strukturen, zum Beispiel bestimmter extern (*ex situ*) gebildeter Maskenstrukturen. Eine weitere Möglichkeit der Bereitstellung eines geeigneten Startsubstrats kann die Bildung von Zwischenschichten oder Zwischenstrukturen zum Zweck einer Unterstützung der späteren Ablösung vom Ausgangssubstrat, und/oder die Bildung eines sogenannten GaN-"Nanorasens" einschließen, bei dem man von einem Substrat mit darauf gebildeter GaN-Komplianzschicht mit Nanosäulenstruktur ausgeht, wie beispielsweise in WO2006035212A1, WO2008096168A1, WO2008087452A1, EP2136390A2 und WO2007107757A2 beschrieben.

Eine gegebenenfalls ex situ durchgeführte Musterung wie z.B. das Öffnen von Fenstern und anderer Maskenstrukturen gehört somit allenfalls zum Schritt der Bereitstellung des Startsubstrats, jedoch nicht zum eigentlichen Schritt des Einbringens der Masken-Zwischenschicht, wie nachfolgend im Zusammenhang mit dem erfindungsgemäßen Verfahren beschrieben.

Für die Bereitstellung eines Startsubstrats wird ein Fremdsubstrat mit Saphir verwendet, bevorzugt besteht es aus Saphir. Weiter bevorzugt wird ein Saphirsubstrat mit c-Orientierung verwendet mit einer Verkippung nach (1-100) oder (11-20) um 0,1-0,5° und einseitiger epi-ready-Politur und polierter und/oder vorzugsweise geläppter Rückseite. Eine weitere Ausführungsform sieht vor, dass das Startsubstrat eine durch Lithographie oder durch nasschemische oder trockenchemische Ätzverfahren (z.B. ICP-Ätzen) strukturierte Oberfläche aufweist.

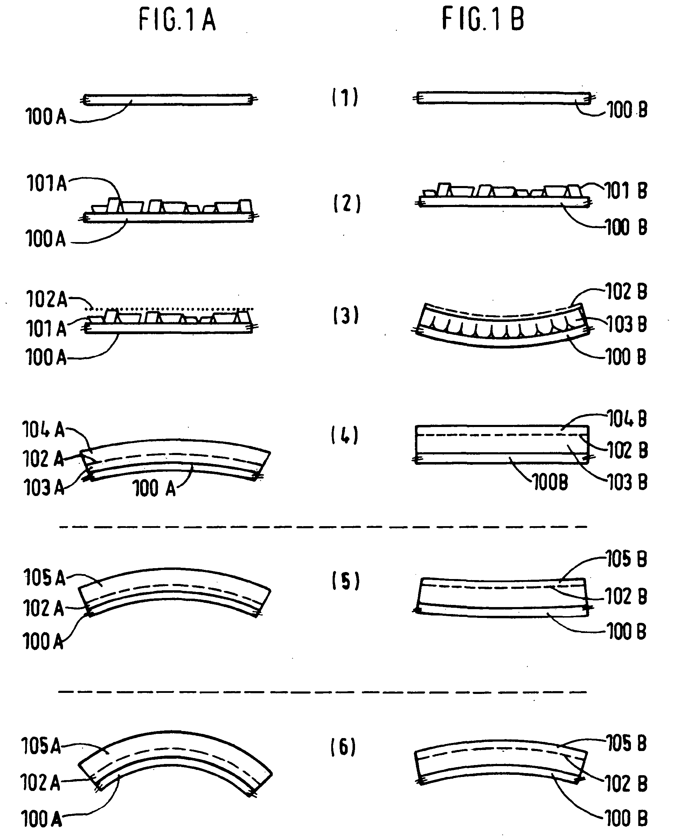

Beispielhafte, nicht einschränkende, jedoch jeweils variierte Ausführungsformen werden nun anhand der schematischen Fig. 1A und 1B beschrieben. An dieser Stelle sei angemerkt, dass die Dicke eines Substrats (Bz. 100A bzw. 100B) substantiell größer ist als die Dicken von III-N-Material und - Schichten, die darauf gebildet werden, und ferner dass ein Hauptteil der aufgewachsenen III-N-Schicht des Templats (Bz. 105A bzw. 105B) substantiell größer ist als eine Dicke von III-N-Material (Bz. 103A bzw. 103B) unterhalb der Zwischenschicht mit Maskenmaterial (Bz. 102A bzw. 102B), was durch jeweilige Unterbrechungen am jeweils linken Rand der Schichten 100A/100B und 105A/105B angedeutet ist. In den Figuren 1A und 1B ist zunächst im gleichen Schritt (1) die Bereitstellung der jeweilige Substrate 100A bzw. 100B gezeigt. Die jeweiligen Substrate können optional wie oben beschrieben vorbehandelt sein, insbesondere können diese jeweils einem Desorptionsschritt und einem Nukleationsschritt unterzogen sein. In einem solchen optionalen Desorptionsschritt können zum Beispiel Kohlenwasserstoffreste, aber auch andere flüchtige Verunreinigungen vom Startsubstrat oder strukturiertem oder anders vorbehandeltem Substrat entfernt werden. Während des Desorptionsschritts wird das Startsubstrat im Verfahren auf eine erhöhte Temperatur aufgeheizt, vorzugsweise auf eine Temperatur von 1100 bis 1300°C, weiter bevorzugt auf eine Temperatur von 1150 bis 1250°C, z.B. ungefähr um 1200°C. Typischerweise wird das Startsubstrat aufgrund des Temperaturgradienten innerhalb des Substrats einer Verbiegung (Verkrümmung, Krümmung) unterworfen, normalerweise mit einer konkaven Krümmung bezüglich der Oberfläche, auf der nachfolgend das III-N-Material aufgetragen wird. Dem Desorptionsschritt kann ferner optional eine Nitridierung mit Ammoniak folgen. Ein weiterer optionaler Schritt besteht darin, dass nach erfolgter Desorption die Temperatur abgesenkt wird, beispielsweise auf eine Temperatur zwischen 400 und 600°C, bevorzugt auf eine Temperatur zwischen 450 und 550 °C. Während dieses Abkühlens nimmt die - typischerweise konkave - Krümmung wieder ab, zum Beispiel auf das Niveau wie zu Beginn des Aufheizens zum Desorptionsschritt.

Das Bereitstellen und Vorbehandeln eines Substrates im Verfahren zur Herstellung eines Templates der vorliegenden Erfindung kann vorzugsweise ferner einen Nukleationsschritt umfassen, bei dem kristallines III-N-Material, speziell winzige III-N-Kristallite auf das Startsubstrat aufgewachsen werden. Dieser Schritt ist schematisch im insoweit gleichen Schritt (2) der Fig. 1A und 1B dargestellt. Das kristalline III-N-Material 101A bzw. 101B, speziell die III-N-Kristallite dienen als Kristallisationskeime im späteren weiteren III-N-Kristallwachstum. III-N-Kristallite weisen Größen von z. B. 1 bis 40 nm mit unregelmäßigen Formen auf, liegen in der Regel ungeordnet auf dem Startsubstrat vor und bilden geeigneterweise zunächst eine nicht zusammenhängende Nukleationsschicht. Dieser Nukleationsschritt findet im Falle einer Niedertemperatur-GaN-Nukleation typischerweise bei Temperaturen von 400 bis 600 °C, vorzugsweise von 450 bis 550 °C statt und mehr bevorzugt von 500 bis 540 °C.

Eine AlN-Nukleation findet typischerweise bei Temperaturen von 850 bis 1050 °C, vorzugsweise von 900 bis 1000 °C und mehr bevorzugt von 950 bis 960 °C statt.

Beim Niedertemperatur-Nukleationsschritt, gegebenenfalls auch beim anschließenden Aufheizen auf Wachstumstemperatur, kann optional eine Rekristallisation erfolgen.

Nach dem Bereitstellen eines Substrates, ggf. mit den oben beschriebenen optionalen Maßnahmen, können die weiteren Schritte der jeweiligen erfindungsgemäßen Ausführungsformen variieren, was Zeitpunkt und Position/Lage der Schicht des Maskenmaterials und die daraus resultierenden Konsequenzen anbelangt, wie jeweils getrennt in Fig. 1A und Fig. 1B veranschaulicht.

Bei der in Fig. 1A gezeigten Ausführungsform wird bereits direkt auf die Nukleationsschicht 101A, noch bevor Koaleszenz der Kristallite eintritt, eine Zwischenschicht aus Maskenmaterial 102A aufgebracht. In einer weiteren (hier nicht speziell dargestellten) Modifikation erfolgt diese Abscheidung der Zwischenschicht nicht direkt auf der Nukleationsschicht, sondern erst nach einer sehr kurzen Phase eines III-N-Wachstums, aber noch sehr nahe im nm-Bereich an der Nukleationsschicht, zum Beispiel in einem Bereich von bis 30nm Abstand. In diesem sehr nah an der Nukleationsschicht gewählten Abstandsbereich laufen die nachfolgenden Schritte praktisch analog der in Fig. 1A gezeigten Form ab. Bei der in Fig. 1B gezeigten Ausführungsform wird auf der Nukleationsschicht 101B zunächst für eine bestimmte, in der Regel nach wie vor relativ kurze Zeit ein III-N-Wachstum durchgeführt, zum Beispiel bis sich eine geringe Dicke von 30 nm oder darüber und geeigneterweise bis ca. 300 nm, vorzugsweise bis ca. 100nm, und erfindungsgemäß bis ca. 50nm der kristallinen III-N-Schicht 103B gebildet hat, und erst dann wird im entsprechenden Abstand von der Nukleationsschicht des Substrats eine Zwischenschicht aus Maskenmaterial 102B aufgebracht.

Die Abscheidung der bezeichneten Zwischenschicht 102A bzw. 102B geschieht zweckmäßig und vorteilhaft in situ im gleichen Reaktor mit einem Prozess, der mit der Technik zum Wachstum der III-N-Schicht kompatibel ist. Dazu werden passende Ausgangsmaterialien oder reaktive Folgeprodukte oder -Spezies des Maskenmaterials im Reaktor bei geeigneter Temperatur und weiteren Parametern, die zur Abscheidung von Maskenmaterial geeignet sind, miteinander zur Reaktion gebracht. Am einfachsten erfolgt eine Abscheidung von Nitrid-Maskenmaterial wie Siliziumnitrid, weil dessen Abscheidung gut mit III-N-Abscheidungstechniken kompatibel ist. Häufig können für diese Abscheidung gleiche oder ähnliche, oder mindestens kompatible Bedingungen hinsichtlich Reaktordruck und -temperatur gewählt werden wie bei der III-N-Abscheidung und im übrigen lediglich geeignete Gaszusammensetzungen und Gasströmungsraten angepasst werden, so dass diese Prozessmodifikation leicht zu handhaben ist. So wird zum Beispiel ein Silangas und Ammoniak in den Reaktor eingeströmt und bei geeignetem Druck und geeigneter Temperatur von z.B. 800 °C bis 1200°C, vorzugsweise etwa 1050 bis 1150°C miteinander zur Reaktion und in Form von $Si_3N_4$ und ggf. weiterer stöchiometrischer oder über- oder unterstöchiometrischer $Si_xN_y$-Zusammensetzungen auf dem vorbereiteten Substrat (100A; 101A) abgeschieden. Der Schritt der Abscheidung anderer Maskenmaterialien als SiN, wie z.B. TiN, $Al_2O_3$, $SiO_2$, WSi, und WSiN, kann ohne weiteres und entsprechend angepasst werden.

Auf der Nukleationsschicht (vgl. Fig. 1A; 101A) oder alternativ auf der sich gerade anwachsenden, aber noch sehr nahe an der Nukleationsschicht befindlichen III-N-Schicht (vgl. Fig. 1B; 101B) bildet sich somit eine Maskenschicht (102A bzw. 102B). Die Maskenschicht kann unterschiedliche Formen aufweisen. Sie ist in der Regel gleichmäßig auf der Oberfläche verteilt und kann dabei eine geschlossene Schicht bilden, alternativ weist sie aber eher mikroskopische/nanostrukturierte Lücken auf; diese Möglichkeiten sind in der Zeichnung schematisch in Form einer gestrichelten Schicht 102A bzw. 102B dargestellt.

Die Dicke der "Zwischenschicht" 102A bzw. 102B, welche jeweils Maskenmaterial umfasst, ist sehr gering, was durch entsprechende Gasströmungsraten und geringe Prozesszeiten eingestellt werden kann; sie liegt geeigneterweise im Nanometer- oder im Subnanometer-Bereich, zum Beispiel unter 5 nm, mehr bevorzugt unter 1 nm, insbesondere bis unter einer Monolage (d.h. 0,2 bis 0,3 nm oder weniger).

Der Abstand der Zwischenschicht 102A bzw. 102B, vom Substrat ist gering, er liegt im Bereich bis maximal 50 nm.

Nach Abscheidung der Zwischenschicht mit Maskenmaterial erfolgt unmittelbar darauf das (fortgesetzte) Wachstum einer III-N-Schicht 104A, 104B (Stufe (4) in Fig. 1A/1B), bis das Templat am Wachstumsende (Stufe (5) in Fig. 1A/1B) eine III-N-Schicht 105A, 105B mit gewünschter Dicke im Bereich von 0,1-10 $\mu$m, vorzugsweise im Bereich von 3 bis 10 $\mu$m aufweist (Gesamtdicke der III-N-Schicht des Templats einschließlich der Zwischenschicht des Maskenmaterials und ggf. Nukleationsschicht). Erfindungsgemäß wird dafür gesorgt, dass die Charakteristika Krümmung (gemessen an der Wachstumsoberfläche) und/oder Verspannung der III-N-Schicht des Templats günstig beeinflusst und für nachfolgende Prozesse ausgenutzt werden. So wird im Gegensatz zur herkömmlichen Verfahrensweise, bei der sich typischerweise eine konkave Krümmung der Wachstumsoberfläche bildet, die dann im Verlauf des weiteren Kristallwachstums, also mit zunehmender Dicke der III-N-Schicht, weiter ansteigt, erfindungsgemäß bewirkt, dass die Krümmung des Templats während des anschließenden weiteren Wachstums einer wachsenden III-N-Schicht 104A bzw. 104B abnimmt, wie in den jeweiligen Schritten (4) von Fig. 1A/1B schematisch gezeigt. So wird im speziellen Fall von Fig. 1A dafür gesorgt, dass unmittelbar im Anschluss an das Abscheiden der Zwischenschicht des Maskenmaterials 101A mit dem Koaleszieren der III-N-Schicht diese anwachsende III-N-Schicht sich - untypisch - negativ/konvex krümmt und sich dabei eine erwünschte kompressive Verspannung im Templat aufbaut. Im speziellen Fall von Fig. 1B liegt zwar zunächst im Schritt (3) eine leicht konkave Krümmung mit tensiler Verspannung im III-N-Kristall 103B vor, jedoch wird in diesem Fall dafür gesorgt, dass die Krümmung zumindest signifikant weniger ansteigt als im Vergleich zu einer Situation ohne Abscheidung der Maskenschicht 102B an geeigneter Lage/Position, ggf. sogar noch eine Abnahme der Krümmung erreicht wird und somit eine Krümmungsdifferenz $K_a$-$K_e \geq 0$ beachtet wird.

Wird das angestrebte Krümmungsverhalten nicht oder nicht allein durch Position/Lage der Zwischenschicht mit Maskenmaterial in passendem Abstand gegenüber der Oberfläche des Fremdsubstrats bzw. der Nukleationsschicht erreicht, kann dieses Verhalten durch zusätzliches und gezieltes Einstellen anderer Prozessparameter zu dem Zweck gesteuert werden, dass ein ergänzender Beitrag zu der Beziehung $K_a$-$K_e \geq 0$ geliefert wird, oder dass das Templat bei Wachstumstemperatur im wesentlichen nicht gekrümmt ist oder negativ gekrümmt ist. Ein zu diesem Zweck besonders geeigneter, neuer weiterer Prozessparameter besteht in einer Anpassung und ggf. einem Variieren der III-N-Wachstumstemperatur. Für den Fall der Verwendung von Saphir als Fremdsubstrat, welcher einen höheren thermischen Ausdehnungskoeffizienten aufweist als der zu wachsende III-N-Kristall, erfolgt das Wachstum/die Abscheidung bei einer gegenüber vorherigem Wachstum abgesenkten Wachstumstemperatur. Diese Temperaturveränderung wird am effektivsten während einer begrenzten, vorzugsweise relativ frühen Phase des Wachstums der III-N-Schicht des Templats durchgeführt und das Wachstum wird bei dieser verringerten Temperatur fortgesetzt. Eine substanzielle Krümmungsreduzierung mit $K_a$-$K_e > 0$ wird zum Beispiel ergänzend dadurch erreicht, dass in mindestens einer Wachstumsphase des III-N-Kristalls des Templats bei einer gegenüber vorherigem Wachstum um mindestens 10 °C abgesenkten Wachstumstemperatur erfolgt. Die Absenkung der Wachstumstemperatur beträgt vorzugsweise mindestens 20 °C und liegt weiter bevorzugt im Bereich von 20-50 °C und insbesondere im Bereich von 25-40 °C.

Im Falle von GaN liegt eine übliche Wachstumstemperatur beispielsweise im Bereich von 900 °C bis 1200°C, vorzugsweise etwa 1020 bis 1150°C, weiter bevorzugt um ca. 1.100°C ± 20°C,. Im Falle von AlGaN mit einem Al-Anteil von 30% bis zu 90 % liegt eine übliche Wachstumstemperatur beispielsweise im Bereich von 1.070-1.250°C, bevorzugt bei 1.090-1.270°C, und weiter bevorzugt bei 1.170°C. Temperaturen für das Abscheiden anderer III-N-Materialien werden auf der Basis allgemeinen Wissens entsprechend angepasst.

Falls ggf. angewandt und optional erwünscht, kann wie in der oben bezeichneten speziellen Ausführungsform beschrieben das System zunächst auf eine entsprechend vorgewählte (erste) Temperatur gebracht werden, wobei bei dieser ersten Temperatur ggf. nur eine Rekristallisation stattfindet, und diese erste Temperatur dann variiert wird, jedoch nur so weit auf eine veränderte (zweite) Temperatur, bei der weiterhin Kristallwachstum und vorzugsweise epitaxiales Kristallwachstum stattfinden kann, um schließlich das Krümmungsverhalten wahlweise zusätzlich zu beeinflussen. Wenn optional angewandt, geschieht dies vorzugsweise bei Beginn oder während der Koaleszenz der wachsenden III-N-Kristallite oder in der frühen Phase der wachsenden III-N-Schicht des Templats. Wegen der Wahl von Saphir als Fremdsubstrats erfolgt eine Absenkung der Wachstumstemperatur. Beim Fortsetzen des (vorzugsweise epitaxialen) Kristallwachstums im Bereich der entsprechend variierten zweiten Wachstumstemperatur - d.h. unterhalb der jeweils ersten Temperatur - nimmt dann jeweils die Krümmung der Wachstumsoberfläche weiter kontinuierlich oder intermittierend ab. Sobald eine ausreichende ergänzende Krümmungsabnahme über diesen optionalen Schritt der Temperaturvariation erreicht ist, kann die Temperatur für das weitere Wachstum der III-N-Schicht wieder frei gewählt werden, z.B. im Bereich der üblichen vorgenannten Wachstumstemperaturen, wie etwa für GaN und AlGaN.

Die III-Komponente, ausgehend von vorangehenden Schritten - etwa bei der Bildung der anfänglichen III-N-Kristallite bzw. der Nukleationsschicht auf dem Substrat wie oben beschrieben - kann beim Wechsel zum Schritt des Wachstums der eigentlichen epitaxialen III-N-Schicht gleich bleiben, oder sie kann alternativ variiert werden. Zum Beispiel kann die Nukleationsschicht (vgl. 102A bzw. 102B in Fig. 1A/B) aus GaN oder AlN gebildet sein, und unabhängig davon kann die epitaxiale III-N-Schicht des Templats (vgl. 104A-105A bzw. 104B-105B in Fig. 1A/B) aus GaN oder AlGaN (vorzugsweise aus GaN) gebildet sein. In einer bestimmten Ausführungsform wird die III-Komponenten nicht verändert.

Wieder auf die hier konkret beschriebenen Ausführungsformen gemäß Fig. 1A und 1B bezogen wird erfindungsgemäß dafür gesorgt, dass durch passende Abscheidung einer einzigen Zwischenschicht des Maskenmaterials 102A bzw. 102B im Zuge des weiteren Wachstums der gesamten III-N-Schicht 105A bzw. 105B des Templats im Mikrometerbereich (üblicherweise bis 10 μm) die Krümmung weiter kontinuierlich abnimmt, im Fall von Fig. 1A mit Tendenz zu weiter negativen Krümmungswerten, im Fall der Fig. 1B hingegen - weil von einer leicht positiven/konvexen Krümmung in Stufe (3) ausgehend - zu einem Zustand von im wesentlichen fehlender Krümmung (vgl. jeweils Stufe (5) in Fig. 1A/1B).

Bezeichnet man den Krümmungswert zu Beginn des Kristallwachstums der III-N-Schicht oder direkt im Anschluss an die Abscheidung der Zwischenschicht des Maskenmaterials (wie z.B. in Fig. 1 etwa bei Stufe (3)) mit "$K_a$" bzw. "$K_A$" ($K_{Anfang}$) und den Krümmungswert zu einem späteren Zeitpunkt (wie z.B. in Fig. 1 bei Stufe (4)) und insbesondere gegen Ende des Wachstums der III-N-Schicht des Templats (etwa gemäß Fig. 1 bei Stufe (5)) mit "$K_e$" bzw. "$K_E$" ($K_{Ende}$), so weist die Krümmungsdifferenz ($K_a - K_e$) des Templats, jeweils gemessen bei Wachstumstemperatur, ein positives Vorzeichen auf. Bevorzugt beträgt $K_a - K_e$ mindestens 5 km$^{-1}$, weiter bevorzugt mindestens 10 km$^{-1}$. Andererseits ist diese Krümmungsdifferenz ($K_a - K_e$) vorzugsweise nicht zu groß gewählt; so sollte sie vorzugsweise nicht größer als 50 km$^{-1}$, weiter bevorzugt nicht größer als 20 km$^{-1}$ betragen.

Durch Erkennung und aktive Beeinflussung dieses Verhaltens und der damit verbundenen Zusammenhänge ist es durch das Verfahren der vorliegenden Erfindung möglich, ein eine erste III-N-Schicht umfassendes Templat herzustellen, das bei epitaxialer Wachstumstemperatur nicht gekrümmt ist, jedenfalls im wesentlichen nicht gekrümmt ist (wie zum Beispiel in Fig. 1B Stufe (5) veranschaulicht), oder negativ gekrümmt ist (wie zum Beispiel in Fig. 1A Stufe (5) veranschaulicht). Durch gestrichelte Linien abgesetzt stellen die Stufen (5) und (6) die jeweiligen Endzustände des fertig hergestellten Templats dar, jeweils bei Wachstumstemperatur (Stufe (5)) bzw. nach Abkühlung bei Raumtemperatur (Stufe (6)).

In einer bevorzugten Ausführungsform der vorliegenden Erfindung werden alle oben in der ersten Ausführungsform beschriebenen Kristallwachstumsschritte, einschließlich des gegebenenfalls durchgeführten Nukleationsschritts, über metallorganische Gasphasenepitaxie (MOVPE, *Metal-Organic Vapor Phase Epitaxy*) durchgeführt. Alternativ oder in Kombination können die zuvor beschriebenen Kristallwachstumsschritte jedoch auch über HVPE durchgeführt werden.

Wenn Schichtdicken von geeigneterweise mindestens 0,1 μm, zum Beispiel im Bereich von 0,1-10 μm, bevorzugt von 2-7,5 μm der wie oben beschrieben gefertigten III-N-Schicht auf dem Substrat aufgetragen werden, wird erfindungsgemäß ein Templat bereitgestellt, welches sich hervorragend als Ausgangstemplat zur Weiterverwendung oder -verarbeitung zum epitaxialen Wachstum weiterer Schichten und insbesondere von weiteren III-N-Schichten eignet und dann dem Problem der Neigung zu Rissbildungen begegnet werden kann, vor allem wenn anschließend deutlich dickere III-N-Schichten wie III-N-Massivkristalle (Ingots, Boules) gewachsen oder abgeschieden werden. Geeignete Techniken zum Wachstum oder Abscheiden dickerer III-N-Schichten wie III-N-Massivkristalle können zum Beispiel ausgewählt werden aus Gasphasenepitaxie (*Vapor Phase Epitaxy,* VPE) - darunter insbesondere die Hydrid-Gasphasenepitaxie (HVPE), Ammonothermalverfahren, Sublimation und dergleichen.

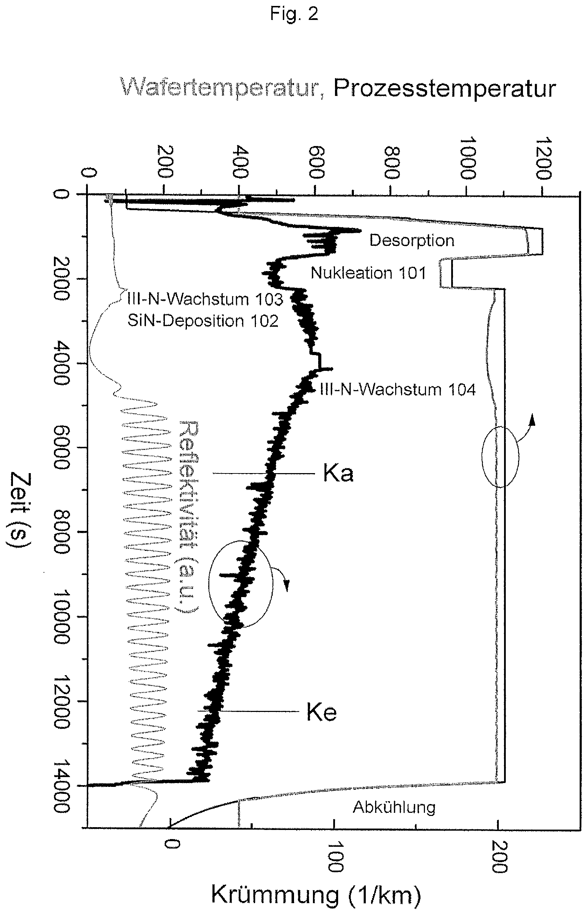

Einen beispielhaften Verlauf des erfindungsgemäßen Verfahrens gemäß einer möglichen Ausführungsform veranschaulicht Fig. 2.

Darin sind folgende Parameter im zeitlichen Verlauf aufgetragen: die Veränderung der wachsenden Oberfläche (erkennbar am Verlauf der abnehmenden Amplitude der Reflektivität, in willkürlichen Einheiten a.u. im unteren Teil der Abbildung) sowie der Temperatur (Ordinate links, obere Linie entsprechend Prozesstemperatur, untere Linie entsprechend Wafertemperatur) und die Veränderung der Krümmung (Ordinate rechts) der Wachstumsoberfläche . Die Messung der Krümmung der Wachstumsoberfläche erfolgt in-situ, durchführbar mit einer EpicurveTT-Krümmungsmessanlage der Firma LayTec (Berlin, Deutschland), die es erlaubt gleichzeitig Daten zur Temperatur, Reflexion und Krümmung der Wachstumsoberfläche zu erhalten.

Einzelne Verfahrensstufen bzw. Abschnitte sind in Figur 2 angegeben. Diese haben entsprechende Parallelen zu der Darstellung in Figur 1. Die Abschnitte, die in Fig. 2 mit "Desorption" und "GaN-Nukleation" bezeichnet sind, entsprechen den in Fig. 1A/1B bezeichneten Stufen (1) und (2) und damit zur Bereitstellung einesSaphirsubstrats. Ohne Abstand bzw. Zeitverzug und damit unmittelbar auf der Nukleation (GaN- oder AlN-Nukleation; vgl. Fig. 1A Stufe (3)), oder nahe daran bzw. nach nur kurzer (ggf. sehr kurzer) Wachstumsdauer (vgl. Fig. 1B Stufe (3)) wird die Zwischenschicht mit Maskenmaterial abgeschieden, wie in Fig. 2 angezeigt. Der mit dem Ausdruck "GaN-Schicht" bezeichnete Abschnitt entspricht einem epitaxialen III-N-"Kristallwachstum" gemäß den Stufen (4) bis (5) von Fig. 1. Im Zuge des sich an die Zwischenschicht-Abscheidung anschließenden, epitaxialen III-N-Kristallwachstums ist die technische Realisierung erkennbar, dass die Krümmung ausgehend von $K_A$ im zeitlichen Verlauf abnimmt, bis zum Ende des Wachstums der III-N(GaN)-Schicht des Templats die um ca. 20-30km$^{-1}$ geringere Krümmung $K_E$ (im Vergleich zu $K_A$) erreicht ist. Abschließend kann auf Raumtemperatur abgekühlt werden (vgl. Fig. 1A/B Stufe (6)). Mit einer solchen Verfahrensweise wird es möglich, dass die III-N(GaN)-Schicht des Templats am Ende bei Wachstumstemperatur, d.h. bei einer Dicke im Bereich einiger $\mu$m, im wesentlichen nicht gekrümmt ist; z.B. kann der Krümmungswert ($K_E$) bei epitaxialer Wachstumstemperatur im Bereich von maximal $\pm 30$ km$^{-1}$, eher noch bei $\pm 20$ km$^{-1}$ um null liegen. Die Verfahrensweise kann, falls erwünscht, so variiert werden, dass am Ende $K_E$ bei Wachstumstemperatur negativ ist und somit das Templat eine konvexe Krümmung aufweist. Nach Abkühlung auf Raumtemperatur zeigt das Templat eine deutlich verstärkte konvexe Krümmung und somit eine merkliche kompressive Verspannung. Wird dieses Templat zu einem gewünschten Zeitpunkt - etwa zum Aufwachsen eines dicken III-N-Massivkristalls - wieder auf Wachstumstemperatur aufgeheizt, wird wieder der Zustand mit im wesentlichen fehlender oder alternativ negativer Krümmung erreicht, was nach den überraschenden erfindungsgemäßen Erkenntnissen eine ausgezeichnete Grundlage für weiteres epitaxiales III-N-Wachstum mit verringerter Neigung zur Rissbildung schafft.

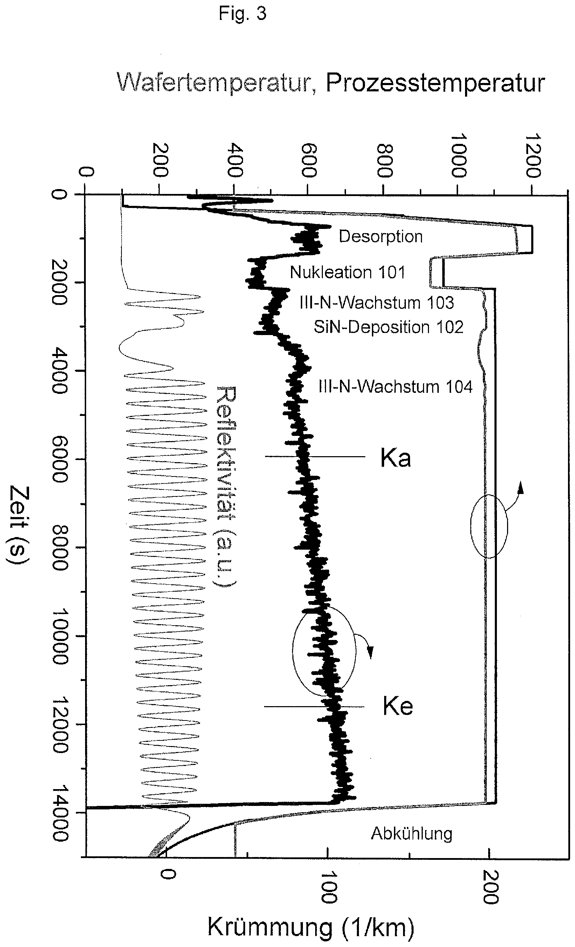

In Fig. 3 ist ein entsprechender Verlauf (Darstellung und Beschriftung wie in Fig. 2 angegeben) anhand von Saphirproben als Ausgangssubstrate gezeigt, wenn anders als in Fig. 2 eine Zwischenschicht aus Maskenmaterial deutlich später abgeschieden wird (nämlich 300 nm). Zwar nimmt, anders als im Fall der Fig. 2, bei dem die Maskenmaterial-Zwischenschicht in sehr geringem Abstand von 15nm abgeschieden wurde, im Fall von Fig. 3 eine konkave Krümmung zu (d.h. $K_A$-$K_E$ ist < 0). Allerdings zeigt auch die Ausführung nach Fig. 3, dass mit einer vorbestimmten Festlegung des Abstands der Krümmungsgrad im erhaltenen Templat gezielt je nach Wunsch eingestellt werden kann. Entsprechend zeigt das Templat von Fig. 3 nach Abkühlung auf Raumtemperatur eine deutlich geringere konvexe Krümmung als das Templat der Fig. 2. Im Hinblick auf die Vermeidung von Rissbildungen bei weiterem epitaxialen III-N-Wachstum, insbesondere mit dickeren III-N-Schichten, ist die Abscheidung der Maskenmaterial-Zwischenschicht mit sehr geringem Abstand (etwa von 0nm bis etwa 50nm, vgl. stellvertretend Fig. 2 mit beispielhaftem Abstand von 15 nm) stark vorteilhaft, hier im Vergleich zum Ergebnis nach Fig. 3 mit Abstand von etwa 300 nm.

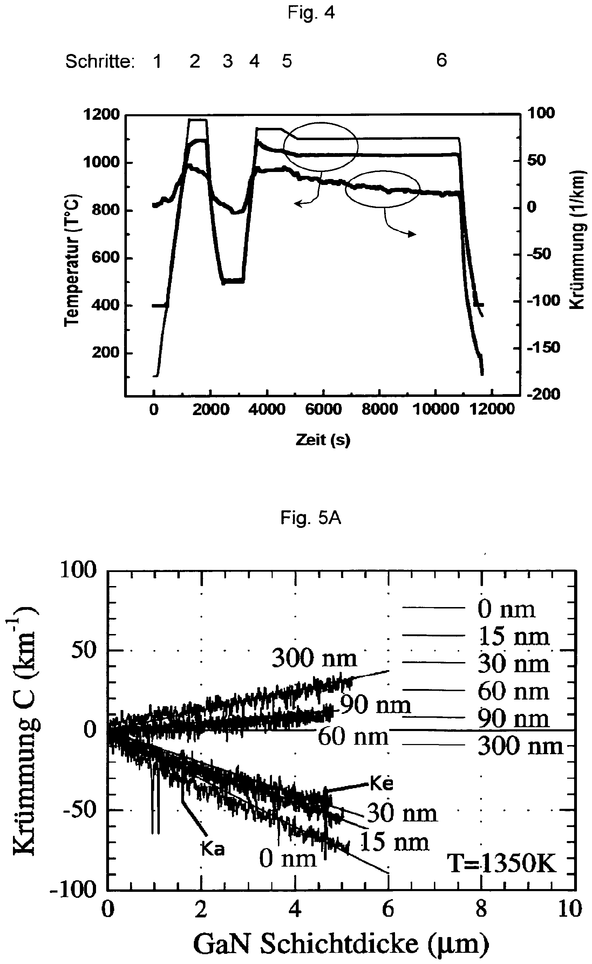

Fig. 4 zeigt schematisch in einer möglichen Variante die zu erwartende Veränderung der Krümmung der Wachstumsoberfläche (rechte Ordinate) und jeweils angewandter Temperatur (linke Ordinate, obere Linie entsprechend Prozesstemperatur, untere Linie entsprechend Wafertemperatur) für den Fall einer möglichen weiteren Ausführungsform der vorliegenden Erfindung, bei der optional eine Abscheidung einer Zwischenschicht mit Maskenmaterial kombiniert wird mit einer Verringerung der III-N-Wachstumstemperatur während des Wachstums der III-N-Schicht des Templats. In dieser möglichen und optionalen Ausführungsform wird nach Bereitstellung eines Saphir-Fremdsubstrats, die auch das Aufbringen einer sehr dünnen GaN- oder AlN-Nukleationsschicht einschließt (in der Graphik erkennbar in den Abschnitten einer anfänglichen Hochtemperatur- mit anschließender Tieftemperaturphase), zunächst wieder auf Wachstumstemperatur aufgeheizt, dann ggf. eine - hier nicht gezeigte - Rekristallisationsphase angeschlossen, um dann wie oben beschrieben eine Zwischenschicht mit Maskenmaterial abzuscheiden, was wie beschrieben zum Beispiel zu einem Zeitpunkt erfolgen kann, wenn bereits eine über 50 nm, oder eine über 100 nm und oder eine z.B. 300 nm dicke III-N-Schicht gewachsen ist. Zusätzlich und im Unterschied zu den in Fig. 1 und 2 dargestellten Basis-Ausführungsformen wird nun aber, entweder gleichzeitig mit dieser Zwischenschichtabscheidung oder in einem bestimmten, vorzugsweise kurzen Zeitraum davor oder danach eine Temperaturabsenkung (vgl. die in Fig. 4 angezeigte Temperaturrampe von ca. 30°C nach Anheben auf Wachstumstemperatur) angewandt und dann das Wachstum der III-N-Schicht des Templats bei dieser abgesenkten Temperatur fortgesetzt, um einen zusätzlichen Beitrag zur Krümmungsreduzierung zu erhalten. Im Gesamtergebnis dieser Kombination ist zu erwarten, dass die Krümmung des Templats an der Wachstumsoberfläche im Zuge des weiteren Wachstums abnimmt, d.h. $K_A$-$K_E$ deutlich über null liegt, wie im Prinzip in Fig. 4 veranschaulicht.

Alternativ zu einer Temperaturabsenkung zum fortgesetzten Wachstum der III-N-Schicht des Templats können weitere Prozessparameter angewandt werden, um für die Einhaltung der Beziehung $K_A$-$K_E$ > 0 zu sorgen.

Weitere Möglichkeiten und verschiedene Ausführungsformen zur Steuerung von Krümmung und/oder von Verspannung in der III-N-Schicht des Templats, um auf dieser Basis mindestens eine weitere III-N-Schicht und ggf.

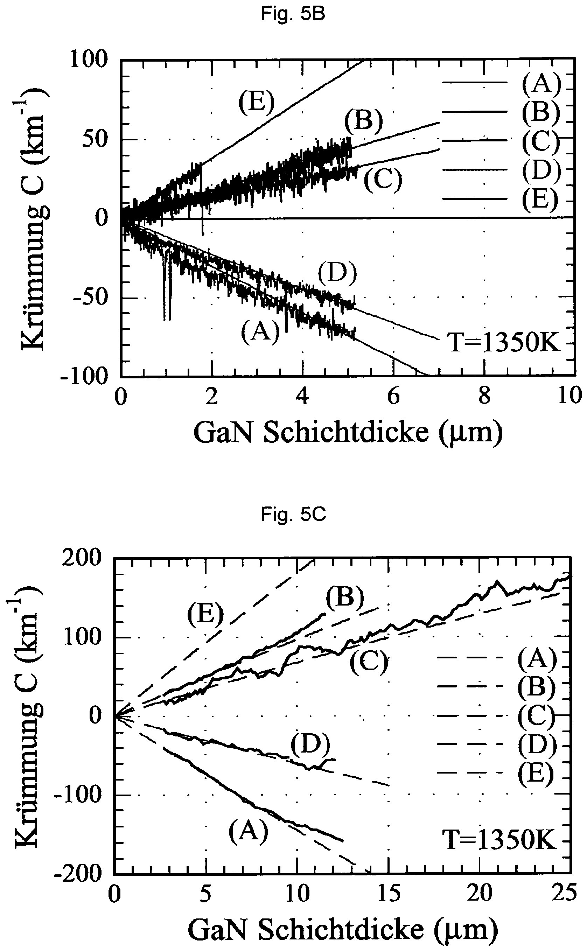

einen dicken Massivkristall mit verringerter Neigung zur Rissbildung auf dem Templat aufzubringen, sind aus Fig. 5A, 5B und 5C ersichtlich, wobei Fig. 5B und 5C noch Ergebnisse zu Vergleichen ohne Zwischenschicht enthalten (jeweils Linien (B) und (E)). In Fig. 5A-C ist das Krümmungsverhalten der III-N-Schicht des Templats bei Wachstumstemperatur gegen deren Dicke aufgetragen. Dabei zeigen Fig. 5A und 5B den Abschnitt der Herstellung von entsprechenden Templaten, wobei hier beispielhaft als Wachstumstechnik die MOVPE verwendet wurde, wohingegen Fig. 5C einen späteren Abschnitt der Herstellung von dickeren III-N (hier GaN)- Schichten unter Verwendung dieser entsprechenden Templaten zeigt, wobei hier die Wachstumstechnik der HVPE verwendet wurde, welche sich zur Herstellung dickerer Schichten bis hin zu Msssivkristallen besonders gut eignet.

Die Ergebnisse zeigen einen konsistenten Trend, dass der Krümmungsverlauf signifikant dadurch beeinflusst wird, wie der Abstand einer einzigen Zwischenschicht von Maskenmaterial gegenüber Saphir-Ausgangssubstrat bzw. einer optionalen Nukleationsschicht darauf eingestellt ist. Es ist ersichtlich, dass bei der verwendeten experimentellen Konstellation im hier verwendeten System Saphir/GaN die Bedingung $K_a$-$K_e$>0 für die Fälle ohne Abstand (d.h. Linie "0nm") und für die Fälle von Abständen "15nm" und "30nm" sicher erfüllt ist und offensichtlich noch für Abstände bis etwa 50nm. Bei größeren Abständen von über 50nm, d.h. wie gezeigt bei 60 nm, 90 nm und 300 nm, ist diese Bedingung primär nicht erfüllt, aber überraschenderweise ist der Anstieg der Krümmung vergleichsweise stark gedämpft mit der Folge, dass ein solcher Anstieg kleiner gehalten werden kann als in Fällen, in denen keine Zwischenschicht von Maskenmaterial aufgebracht wurde (vgl. Fig. 5B und C, Vergleichslinien (B) und (E)), und insbesondere wenn auf eine bei niedriger Temperatur abgeschiedenen Nukleationsschicht (LT-GaN-Nukl) gewachsen wurde (vgl. Fig. 5 Bund C, Vergleichslinie (E)). Die erfindungsgemäße Verfahrensweise zeigt die wesentlich bessere Steuerbarkeit günstiger Templateigenschaften sowie die Möglichkeit, Templatkrümmungen nach Wunsch genau einzustellen, was für das weitere III-N-Epitaxiewachstum genutzt werden kann.

So bestätigt Fig. 5A, dass das Vorsehen von nur einer Zwischenschicht von Maskenmaterial in kontrolliert eingestelltem Abstand gegenüber Saphir-Ausgangssubstrat, ggf. mit darauf gebildeter optionaler Nukleationsschicht, eine sehr präzise Einstellung und Kontrolle eines gewünschten Krümmungswerts zulässt. Ferner ist zu erkennen, dass unter Beachtung relevanter Faktoren wie Abstand der Zwischenschicht von Maskenmaterial und Dicke der gewachsenen III-N-Schicht und damit der Wachstumsdauer ein solcher Zustand im entsprechend fertigen, Substrat-gebundenen III-N-Templat eingestellt werden kann, bei dem das Templat gemäß dem alternativen Lösungsprinzip zur Vermeidung von Rissbildungen bei Wachstumstemperatur nicht oder im wesentlichen nicht gekrümmt ist oder negativ gekrümmt ist, d.h. die Krümmung auf höchstens 30km$^{-1}$, besser auf höchstens 20km$^{-1}$ oder noch besser auf höchstens 10km$^{-1}$ begrenzbar ist oder vorzugsweise sogar auf negative Werte einstellbar ist. Darüber hinaus ist es wie beschrieben möglich, die Differenz mit weiteren Prozessparametern wie Temperaturvariationen beim Wachstum der III-N-Schicht des Templats ergänzend zu beeinflussen, und falls gewünscht dafür zu sorgen, dass die spezielle Beziehung sicher $K_A$-$K_E$ > 0 eingehalten wird.

Das erfindungsgemäß erhaltene Templat weist vorteilhafte Eigenschaften und Merkmale auf, die nachfolgend weiter beschrieben werden. Es ist als solches ein interessanter kommerzieller Gegenstand, es kann aber auch direkt anschließend oder alternativ indirekt nach Bereitstellung, Lagerung oder Versenden, als Templat im Rahmen unten beschriebener weiterer Schritte weiterverarbeitet werden.

Ein Templat zur Herstellung von weiterem III-N-Einkristall gemäß der vorliegenden Erfindung ist im Temperaturbereich eines epitaxialen Kristallwachstums nicht gekrümmt oder im wesentlichen nicht gekrümmt, oder es ist negativ gekrümmt. Wenn zum Beispiel für das Templat als Substrat Saphir einer Dicke ($d_{Saphir}$) von 430$\mu$m (ungefähr, d.h. $\pm$20$\mu$m) und als III-N-Kristallschicht GaN einer Dicke ($d_{GaN}$) von 7 $\mu$m (ungefähr d.h. $\pm$0,5$\mu$m) verwendet oder eingestellt wird, so ist der Ausdruck "im wesentlichen nicht gekrümmt" vorzugsweise so definiert, dass der Krümmungswert ($K_e$) bei epitaxialer Wachstumstemperatur im Bereich von maximal $\pm$30 km$^{-1}$, bevorzugt im Bereich von maximal $\pm$10 km$^{-1}$ um null liegt; der Ausdruck "nicht gekrümmt" bedeutet dann einen $K_e$-Wert ungefähr null, z.B. 0$\pm$5 km$^{-1}$ und insbesondere 0$\pm$2 km$^{-1}$; und der Ausdruck "negativ gekrümmt" ist dann definiert durch eine Krümmung bei Wachstumstemperatur im Bereich von unter 0 km$^{-1}$, zum Beispiel im Bereich bis -150 km$^{-1}$, weiter bevorzugt im Bereich von -25 bis -75 km$^{-1}$.

Es ist zu beachten, dass bei Verwendung anderer Materialien für III-N als GaN der exakte Krümmungswert variieren kann; erfindungsgemäß bleibt es aber bei der beabsichtigten Einstellung einer (im wesentlichen) Nichtkrümmung oder einer negativen Krümmung. Ferner kann bei Einstellung anderer Schichtdicken der Krümmungswert in Abhängigkeit der jeweiligen Schichtdicken analog der folgenden vereinfachten Stoney-Gleichung variieren, wonach - sofern der Film ($d_{III-N}$) wesentlich dünner ist als das Substrat ($d_{Substrat}$) - die Beziehung gilt [wobei R= Krümmungsradius und $\varepsilon_{xx}$=Deformation (strain)]:

$$1/R = 6*(d_{III-N}/d^2_{Substrat})*\varepsilon_{xx}.$$

Unter der Annahme einer sehr dünnen Schicht wird $\varepsilon_{xx}$ als konstant angenommen, d.h. wenn sich die Schichtdicken ändern, reagiert das System mit einer Änderung von R (die aus einer Änderung der Krümmung resultierende Änderung von $\varepsilon_{xx}$ wird vernachlässigt). Somit liegt bei Verwendung der beispielhaften Materialien Saphir und GaN, aber bei Einstellung anderer als den vorgenannten Schichtdicken ($d_{Saphir}/d_{GaN}$) der Krümmungswert in Abhängigkeit der jeweiligen Schichtdicken analog der Stoney-Gleichung in folgenden Bereich:

$$K_{T(dGaN;dSaphir)}=K_{T(7\mu m;430\mu m)}x(430\mu m/d_{Saphir})^2x(d_{GaN}/7\mu m),$$

wobei im Fall der Wahl anderer Materialien diese Gleichung mit entsprechenden Werten $d_{Substrat}/d_{III-N}$ berechnet wird.

Für ein erfindungsgemäßes Templat bedeutet dies zum Beispiel ferner, dass wenn bei 430$\mu$m Saphir und einer 3,5-4$\mu$m dicken GaN-Schicht eine Krümmung von 250km$^{-1}$ vorliegt, sich bei einem 330$\mu$m dicken Saphir-Wafer beim selben Prozess eine Krümmung von 425km$^{-1}$ ergibt.

Es ist ferner zu beachten, dass die Krümmung bei Raumtemperatur im Vergleich zur Krümmung bei Wachstumstemperatur verändert ist, unter Umständen deutlich verändert sein kann. Bei Verwendung von Saphir als Fremdsubstrat zum Beispiel wird dem Templat - infolge der plastischen Verformung während des Abkühlens von der Wachtumstemperatur auf Raumtemperatur, hauptsächlich aufgrund der unterschiedlichen thermischen Ausdehnungskoeffizienten der unterschiedlichen kristallinen Materialien - zusätzlich eine (nur durch extrinsische Kompression erzeugte) Spannung aufgeprägt. Dies soll in Fig. 1A und Fig. 1B mit einem Zustand der Endstufe (6) des erfindungsgemäß hergestellten Templats bei Raumtemperatur schematisch veranschaulicht werden, wobei gegenüber der Endstufe (5) bei Wachstumstemperatur jeweils eine merklich stärker negative Krümmung vorliegt. Entsprechend wird, ergänzend oder alternativ, darauf geachtet, dass beispielsweise bei den Materialien Saphir und GaN die Krümmung bei Raumtemperatur im Bereich von $K_{T\,(7\mu m;\,430\mu m)}$ <-200 km$^{-1}$, vorzugsweise -200 bis -400 km$^{-1}$, bevorzugt im Bereich von -300 bis -350 km$^{-1}$ festgelegt wird; wobei wiederum auf die vereinfachte Stoney-Gleichung für Fälle anderer Schichtdicken, $K_{T(dGaN;dSaphir)}=K_{T(7\mu m;430\mu m)}x(430\mu m/d_{Saphir})^2x(d_{GaN}/7\mu m)$, Bezug genommen wird.

In einer weiteren bevorzugten Ausführungsform weist das Templat bei Raumtemperatur für den Fall $d_{Saphir}$=430$\mu$m und $d_{GaN}$=3,5$\mu$m einen Krümmungsradius im Bereich von -4 bis -6m auf.

Eine weitere Möglichkeit, die Produkt- oder Struktureigenschaften des erfindungsgemäß erhaltenen Templats charakteristisch zu beschreiben, ist durch die Angabe der Deformation der Gitterkonstanten oder der Verspannung möglich.

Die Deformation $\varepsilon_{xx}$ ist dabei folgendermaßen definiert:

$$\varepsilon_{xx} = \frac{\text{Gitterkonstante a} - \text{Gitterkonstante a}_0}{\text{Gitterkonstante a}_0}$$

wobei a die tatsächliche Gitterkonstante im Kristall und $a_0$ die theoretisch ideale Gitterkonstante darstellt.

Röntgen-Verfahren zur Bestimmung absoluter Gitterkonstanten werden in M. A. Moram and M. E. Vickers, Rep. Prog. Phys. 72, 036502 (2009) detailliert diskutiert.

Dabei erfolgt die Bestimmung über das Bragg'sche Gesetz

$$n\lambda = 2d_{h\,k\,l}\sin\theta$$

zunächst für die Gitterkonstante c aus einem 2Theta-Scan mit Drei-Achsen-Geometrie in symmetrischen Reflexen wie z.B. 004. Die ideale Gitterkonstante nach V. Darakchieva, B. Monemar, A. Usui, M. Saenger, M. Schubert, Journal of Crystal Growth 310 (2008) 959-965) beträgt c0= 5.18523$\pm$0.00002 Å. Die Bestimmung der Gitterkonstanten a erfolgt dann nach der ebenfalls z.B. in M. A. Moram and M. E. Vickers, Rep. Prog. Phys. 72 (2009) 036502 angegebenen Gleichung

$$\frac{1}{d_{h\,k\,l}^2} = \frac{4}{3}\frac{h^2 + k^2 + hk}{a^2} + \frac{l^2}{c^2}$$

aus asymmetrischen Reflexen hkl wie z.B. -105 im 2Theta-scan. Als ideale Gitterkonstante a0 für unverspanntes GaN kann $a0$ = 3.18926$\pm$0.00004Å nach V. Darakchieva, B. Monemar, A. Usui, M. Saenger, M. Schubert, Journal of Crystal Growth 310 (2008) 959-965) angenommen werden. Zum Hintergrund der Phänomene intrinsische und extrinsische Spannung, u.a. unter Beachtung von Gitterkonstanten, vgl. Hearne et al., Appl.Physics Letters 74, 356-358 (2007).

Ferner können die Eigenschaften auch durch die Verspannung $\sigma_{xx}$ angegeben werden, wobei

$$\sigma_{xx} = M_f \cdot \varepsilon_{XX} \qquad \text{(Hook'sche Formel)}$$

wobei $M_f$ das biaxiale Elastizitätsmodul bedeutet. Die Bestimmung der Verspannung $\sigma_{xx}$ ist durch Ramanspektroskopie einfach möglich, z.B. wie in I. Ahmad, M. Holtz, N. N. Faleev, and H. Temkin, J. Appl. Phys. 95, 1692 (2004) beschrieben; dort wird das biaxiale Elastizitätsmodul 362 GPa als Wert aus der Literatur herangezogen, wobei ein sehr ähnlicher Wert von 359 GPa aus J. Shen, S. Johnston, S. Shang, T. Anderson, J. Cryst. Growth 6 (2002) 240 zu entnehmen ist; somit ist ein Wert für das biaxiale Elastizitätsmodul $M_f$ von etwa 360 GPa passend und konsistent.

Ein Templat gemäß der vorliegenden Erfindung weist im Temperaturbereich eines epitaxialen Kristallwachstums einen Wert $\varepsilon_{xx} \leq 0$ (d.h. einschließlich $\varepsilon_{xx} = 0$), insbesondere aber von $\varepsilon_{xx} < 0$ auf. Dieser Wert lässt sich direkt aus einer *in-situ* Messung der Krümmung bestimmen.

Neben dem Vorliegen einer Zwischenschicht mit Maskenmaterial kann ein Templat gemäß der vorliegenden Erfindung ferner bei Raumtemperatur eine kompressive Spannung von $\sigma_{xx} < -0{,}70$ GPa aufweisen, und/oder die Deformation $\varepsilon_{xx}$ des Templats bei Raumtemperatur kann auf einen Wert im Bereich von $\varepsilon_{xx}<0$, bevorzugt im Bereich $0 > \varepsilon_{xx} \geq -0{,}003$, weiter bevorzugt im Bereich $-0{,}0015 \geq \varepsilon_{xx} \geq -0{,}0025$ (oder $-0{,}0015 > \varepsilon_{xx} \geq -0{,}0025$) und insbesondere im Bereich $-0{,}0020 \geq \varepsilon_{xx} \geq -0{,}0025$ eingestellt sein.

Eine geeignete Krümmungsmessvorrichtung, die in Verbindung mit einer Anlage zur Gasphasenepitaxie einsetzbar ist, ist zum Beispiel die Krümmungsmessvorrichtung der Laytec AG, Seesener Strasse, Berlin Deutschland (vgl. z.B. DE102005023302A1 und EP000002299236A1). Diese Krümmungsmessvorrichtungen lassen sich gut mit verfügbaren Anlagen zur Gasphasenepitaxie, wie der MOVPE, HVPE oder MBE (Molecular Beam Epitxy) kombinieren und ermöglichen zudem eine Messung der Temperatur an der Waferoberfläche.

Demgemäß erhält man nach dem epitaxialen Kristallwachstum ein Templat, das aufgrund der oben beschriebenen Eigenschaften dazu geeignet ist, in weiteren epitaxialen Wachstumsschritten Kristalle von besonderer Güte und mit besonderen Merkmalen herzustellen. Das erfindungsgemäße Templat eignet sich somit hervorragend zur Weiterverwendung, kann also als solches bereitgestellt werden, zwischengelagert oder zur Weiterverwendung verschickt, oder kann direkt in einem Gesamtprozess weiterverwendet werden.

Ein weiterer Gegenstand der vorliegenden Erfindung sieht ein Verfahren zur Herstellung von III-N-Einkristallen vor, wobei III mindestens ein Element der dritten Hauptgruppe des Periodensystems, ausgewählt aus Al, Ga und In, bedeutet, wobei das Verfahren die folgenden Schritte umfasst:

aa) Bereitstellen eines Templats, welches ein Saphir umfassendes Startsubstrat und mindestens eine III-N-Kristallschicht umfasst, wobei das Startsubstrat und die mindestens eine III-N-Kristallschicht so gebildet sind, dass das Templat im Temperaturbereich eines epitaxialen Kristallwachstums keine oder annähernd keine Krümmung aufweist oder eine negative Krümmung aufweist, und

bb) Durchführen eines epitaxialen Kristallwachstums zum Bilden von weiterem III-N-Kristall auf dem Templat gemäß aa), wahlweise zum Herstellen eines III-N-Massivkristalls,

cc) optional Trennen von III-N-Einkristall oder III-N-Massivkristall und Fremdsubstrat.

Dieser Gegenstand der Erfindung geht von dem alternativen Lösungsprinzip aus, die Gefahr von Rissbildungen durch die in den Schritten aa) und bb) festgelegten Voraussetzungen zu minimieren oder ganz zu unterdrücken. Das im Schritt aa) bereitgestellte Templat umfasst in einer bevorzugten Ausführungsform die oben beschriebene Zwischenschicht mit Maskenmaterial, wobei insoweit auf die obige Beschreibung zum Bilden des eine solche Zwischenschicht aufweisenden Templats verwiesen werden kann. Bei diesem Gegenstand der Erfindung nach dem alternativen Lösungsprinzip muss eine solche Zwischenschicht jedoch nicht notwendigerweise vorliegen, weil der im Schritt aa) definierte Krümmungszustand alternativ auch durch andere Bedingungen eingestellt werden kann, speziell durch passende Temperaturkontrolle und -variation während des III-N-Wachstums des Templats, wie ebenfalls an anderen Stellen beschrieben.

Infolge des Einprägens von Gitterdeformation und von kompressiver Spannung gemäß der vorliegenden Erfindung kann der Zustand des im Schritt aa) bereitgestellten Templats auch dadurch definiert werden, dass der III-N-Kristall des Templats bei Wachstumstemperatur einen Wert $\varepsilon_{xx} \leq 0$ (d.h. einschließlich $\varepsilon_{xx} = 0$), insbesondere aber einen $\varepsilon_{xx}$-Wert von $< 0$ aufweist, wobei der Wert bevorzugt im Bereich von $0 > \varepsilon_{xx} > -0{,}0006$ und weiter bevorzugt im Bereich von $-0{,}0003 > \varepsilon_{xx} > -0{,}0006$ liegt. Bei Raumtemperatur kann eine kompressive Spannung von $\sigma_{xx} < -0{,}70$ GPa vorliegen. Die Deformation $\varepsilon_{xx}$ bei Raumtemperatur des erfindungsgemäßen Templats weist bevorzugt einen Wert im Bereich $0 > \varepsilon_{xx} \geq -0{,}003$, weiter bevorzugt im Bereich $-0{,}0015 \geq \varepsilon_{xx} \geq -0{,}0025$ (oder $-0{,}0015 > \varepsilon_{xx} \geq -0{,}0025$) und insbesondere im Bereich $-0{,}0020 \geq \varepsilon_{xx} \geq -0{,}0025$ auf.

So können in einer weiteren Ausführungsform der vorliegenden Erfindung III-N-Einkristalle hergestellt werden, die dadurch gewonnen werden, dass - ohne oder mit Unterbrechung zwischen den Schritten aa) und bb) - ein zusätzliches epitaxiales Kristallwachstum auf dem erfindungsgemäß erhaltenen Templat zum Bilden von weiterem III-N-Kristall durchgeführt wird. Weiteres epitaxiales III-N-Kristallwachstum kann bei einer Wachstumstemperatur durchgeführt werden, die unabhängig von den vorgenannten Kristallwachstumstemperaturen gewählt werden kann.

Auch sonstige Bedingungen des weiteren Kristallwachstums auf dem Templat sind nun frei wählbar. So können III-N-Materialien aufgewachsen werden, deren III-Komponente nach Wunsch gewählt und variiert werden kann. Entsprechend können mindestens eine (ggf. weitere) GaN-, AlN-, AlGaN-, InN-, InGaN-, AlInN- oder AlInGaN-Schicht(en) zur Herstellung entsprechend dickerer III-N-Schichten oder III-N-Einkristalle aufgebracht werden. Bevorzugt bilden sowohl die III-N-Kristallschicht des Templats als auch der darauf epitaxial aufgewachsene III-N-Kristall ein rein binäres System, z.B. GaN, AlN oder InN, oder die III-N-Kristallschicht des Templats ist ein binäres System, insbesondere GaN (mindestens hauptsächlich, da die Nukleationsschicht wahlweise aus einem anderen Material bestehen kann, wie z.B. AlN), und der darauf epitaxial aufgewachsene III-N-Kristall ist ein frei wählbares binäres oder ternäres III-N-Material, insbesondere wiederum binäres GaN.

Schritt bb) kann sich unmittelbar an Schritt aa) anschließen, alternativ kann das Verfahren dazwischen unterbrochen werden. Es ist es möglich, den Reaktor zwischen den Schritten zu wechseln, was wiederum das Aufwachsen von III-N-Kristallen im Schritt bb) über eine andere Aufwachsmethode ermöglicht, als bei der Herstellung des bereitgestellten Templats nach Schritt aa) verwendet wurde, um für die jeweiligen Schritte optimale Bedingungen zu wählen. So wird das zusätzliche epitaxiale Kristallwachstum auf dem erfindungsgemäß hergestellten Templat bevorzugt durch HVPE durchgeführt. Die vorteilhafte Wahl des Schritts bb) unter HVPE-Bedingungen ermöglicht hohe Wachstumsraten und entsprechend das Erreichen dickerer Schichten. Es können aber auch alle Schritte des Verfahrens, welche das gesamte Wachstum einschließlich der Templatbildung und dem anschließenden Abscheiden der weiteren epitaxialen III-N-Schicht betrifft, in einer einzigen Anlage mit einer bestimmten Wachstumstechnik, beispielsweise nur mittels HVPE, durchgeführt werden, so dass die Schritte aa) und bb) in demselben Reaktor durchgeführt werden.

Erfindungsgemäß kann im Verfahren zur Herstellung von III-N-Einkristallen gemäß den oben beschriebenen Ausführungsformen ein epitaxiales Kristallwachstum auf dem bereitgestellten Templat durchgeführt werden, sodass nach Abschluss des epitaxialen Wachstums mit deutlich verringertem Risiko von Rissbildungen dicke III-N-Einkristalle sehr guter Kristallqualität mit Schichtdicken von mindestens 1 mm, bevorzugt von mindestens 5 mm, mehr bevorzugt von mindestens 7 mm und am meisten bevorzugt von mindestens 1 cm erhalten werden. Aufgrund der Rissfreiheit kann vorteilhaft die gesamte Dicke des Massivkristalls genutzt werden.

Nach Beendigung des epitaxialen Kristallwachstums zur Herstellung eines III-N-Einkristalls kann optional der rissfreie III-N-Einkristall vom Substrat getrennt werden (optionaler Schritt cc)). Dies geschieht in einer bevorzugten Ausführungsform durch Selbstablösung, etwa beim Abkühlen von einer Kristallwachstumstemperatur. In einer weiteren Ausführungsform kann das Trennen von III-N-Einkristall und dem Substrat durch Abschleifen, Absägen oder einen lift-off-Prozess erfolgen.

Weist der epitaxial gewachsene III-N-Einkristall eine ausreichend große Dicke auf, wobei ein sogenannter III-N-Boule oder -Ingot erhalten wird, ist es möglich diesen Einkristall durch geeignete Methoden zum Bilden einer Vielzahl von einzelnen dünnen Scheiben (Wafer) zu vereinzeln. Das Vereinzeln der Einkristalle umfasst gängige Methoden zum Zerschneiden oder Zersägen von III-N-Einkristallen. Die so erhaltenen Wafer eignen sich hervorragend als Basis zur Herstellung von Halbleitervorrichtungen und Bauelementen, beispielsweise opto-elektronischen oder elektronischen Bauelementen. So eignen sich die erfindungsgemäß hergestellten Wafer zur Verwendung als Leistungsbauelemente, Hochfrequenzbauelemente, lichtemittierende Dioden und Laser.

In allen Verfahrensstufen, insbesondere bei den eigentlichen, epitaxial gewachsenen III-N-Schichten eines III-N-Boules oder -Ingots und entsprechend im III-N-Einkristall für die erhaltenen Wafer ist der Einschluss von Dotierungen möglich. Geeignete Dotierungen umfassen n- sowie p-Dotierungen und können Elemente umfassen, die ausgewählt sind aus der Gruppe bestehend aus Be, Mg, Si, Ge, Sn, Pb, Se und Te. Für semi-isolierendes Material können geeignete Dotierungen Elemente umfassen, die ausgewählt sind aus der Gruppe bestehend aus C, Fe, Mn und Cr.

In einer weiteren bevorzugten Ausführungsform ist der rissfreie III-N-Einkristall aus Galliumnitrid zusammengesetzt, und dieser Kristall weist in Wachstumsrichtung eine Gitterkonstante $a$ im Bereich von $< a_0$, insbesondere im Bereich von 0,31829 nm $< a \leq$ 0,318926 nm auf. Als Referenzwert der Gitterkonstante $a_0$ von GaN kann hier der Wert $a_0$ =0,318926 nm angenommen werden (vgl. V. Darakchieva, B. Monemar, A. Usui, M. Saenger, M. Schubert, Journal of Crystal Growth 310 (2008) 959-965). Dies entspricht in etwa einer Gitterkonstante c im Bereich von $0 \leq \varepsilon_{zz} < +0,0001$.

## Beispiele

### Beispiel 1

Als Wachstumstechnik wird eine MOVPE auf vorbehandeltem Saphir (der einer Desorption und einer Nukleation unterworfen wird) mit den nachfolgend wiedergegebenen Details verwendet. Die hier genannten Temperaturen beziehen sich auf die nominell eingestellte Temperatur der Heizer; die Temperatur am Templat bzw. Kristall liegt tiefer, teilweise bis um ca. 70 K tiefer (vgl. Fig. 2 und 3: hier ist mit der oberen Linie die Heizertemperatur und mit der unteren Linie die gemessene Temperatur der Waferaufnahme dargestellt).

Reaktor:

MOVPE-Reaktor Aixtron 200/4 RF-S, Einzel-Wafer, horizontal

Fremdsubstrat:

c-plane Saphirsubstrat, off-cut 0,2° in m-Richtung
430 $\mu$m Dicke
unstrukturiert

Desorptionsschritt (Fig. 1 (1); 100)

Reaktordruck: 100 mbar
Aufheizen: Von 400 °C auf 1200 °C in 7 min
Reaktortemperatur: 1200°C
Prozesstemperaturdauer: 10 min in $H_2$-Atmosphäre
Abkühlung auf 960°C

Nukleationsschritt (Fig. 1 (2); 101)

Gasströme: 25 sccm Trimethylaluminium (TMAl), Bubbler: 5° C, 250 sccm $NH_3$
Abkühlung auf 960°C
Öffnen der Ventile
Nukleation: 10 min
Erhöhung des Ammoniakflusses auf 1.6 slm

T-Rampe; ggf. Kristallwachstum (Fig 1 (2) bis vor (3); 103)

Aufheizen von 960 °C auf 1100 °C in 40 sec
Reaktordruck: 150 mbar, $H_2$-Atmosphäre
Gasströme: ggf. 16-26 sccm Trimethylgallium (TMGa), 2475 sccm $NH_3$
Kristallwachstumszeit: 0 - 10 min (entsprechend 0-300 nm)

SiN-Abscheidung (Fig 1 (3); 102)

Gasströme:: 0,113$\mu$mol/min Silan, 1475sccm NH3
Kein TMGa
Druck: 150 mbar
Temp: 1100°C
Dauer: 3 min

weiteres Kristallwachstum: (Fig 1 (4); 104)

1100 °C
Reaktordruck: 150 mbar, $H_2$-Atmosphäre
Gasströme: 26 sccm TMGa, 2000 sccm $NH_3$

Kristallwachstumszeit 90-240 min, entsprechend 3-10 μm GaN-Dicke

Wachstumsende und Abkühlung: (Fig 1 (5)-(6))

Abschalten von Heizung und TMGa-Strom
Reduzierung NH$_3$: 2000 sccm auf 500 sccm in 40 sec
Abschalten: NH$_3$-Strom unter 700 °C
Umschalten: NH$_3$-Strom auf N$_2$-Strom

Fig. 5A zeigt den Verlauf der Krümmung bei Wachstumstemperatur (1350°K), aufgetragen gegen die Dicke der gewachsenen GaN-Schicht und damit im zeitlichen Verlauf, unterschieden je nach Abstand der SiN (Si$_x$N$_y$) gegenüber der AlN-Nukleationsschicht. Der Nullpunkt bezieht sich hierbei auf den Beginn des fortgesetzten Wachstum der III-N-Schicht 104A,104B (d.h. nach Stufe (3) und vor bzw. bei Stufe (4) in Fig. 1A/1B) Das Krümmungsverhalten kann gezielt und präzise gesteuert werden. Die nachfolgende Tabelle 1 gibt die in situ, also bei Wachstumstemperatur gemessenen $\varepsilon_{xx}$-Werte und die bei Raumtemperatur gemessenen Krümmungswerte C (km$^{-1}$) und die über C ermittelten $\varepsilon_{xx}$-Werte bei Raumtemeratur gegen Ende der Templatfertigung mit jeweiligen Dicken um ca. 7 μm wieder.

Tabelle 1

| Distanz AlN und SiN | Dicke (μm) | ε in-situ | C @ RT (km$^{-1}$) | ε @ RT |
|---|---|---|---|---|
| 0 nm | 7,21 | -6,00E-04 | -396 | -2,27E-03 |
| 15 nm | 7,09 | -4,50E-04 | -365 | -2,13E-03 |
| 30 nm | 6,76 | -4,00E-04 | -367 | -2,24E-03 |
| 60 nm | 6,73 | 1,10E-04 | -298 | -1,83E-03 |
| 90 nm | 6,81 | 1,00E-04 | -299 | -1,82E-03 |
| 300 nm | 7,29 | 2,50E-04 | -293 | -1,66E-03 |

**Beispiel 2 und Vergleichsbeispiele**

Auf ausgewählten, gemäß Beispiel 1 hergestellten Templaten, bei denen GaN-Schichten mit SiN-Zwischenschichten direkt auf der Nukleationsschicht (Probe A; nicht erfindungsgemäß) oder nach sehr geringen (15-30nm; Probe D) oder größeren (300 nm; Probe C; nicht erfindungsgemäß) Abständen abgeschieden wurden oder gemäß Vergleichsbeispielen bei denen GaN ohne SiN (Probe B) oder auf Niedrigtemperatur-GaN-Nukleationsschicht (Probe E) gewachsen waren, wurde analog zu Beispiel 1 die Krümmung verfolgt, und zwar im Bereich eines MOVPE-Wachstums bis ca. 7 μm wie in Fig. 5B gezeigt, oder bei Durchführung von weiterem HVPE-Wachstum bis ca. 25 μm wie in Fig. 5C gezeigt. Die Ergebnisse der Figuren 5B und 5C zeigen nochmals das deutlich bessere Ergebnis hinsichtlich Einstellung und Verhalten der Krümmung der erfindungsgemäßen Template (A), (C) und (D) im Vergleich zu den Vergleichstemplaten (B) und (E) ohne SiN-Zwischenschicht.

**Weitere Vergleichsbeispiele**

In weiteren Vergleichsbeispielen können wiederum ähnliche Versuchsbedingungen verwendet werden, außer dass keine Zwischenschicht von Maskenmaterial abgeschieden wird.

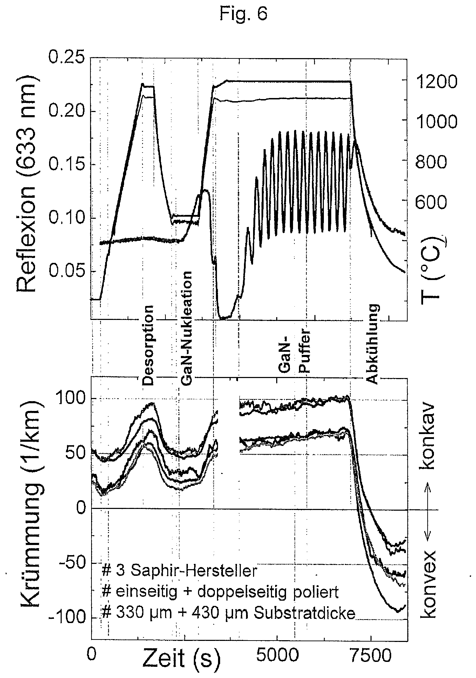

Fig. 6 zeigt typische in-situ Daten des MOVPE-Wachstums von GaN auf Saphir in einem weiteren Vergleichsbeispiel, wobei in der unteren Graphik die Entwicklung der Verkrümmung während des Prozesses für drei unterschiedliche Saphirsubstrate gezeigt ist (vgl. Brunner et al. in J. Crystal Growth 298, 202-206 (2007)). Die Pfeile verweisen auf die abzulesenden Krümmungswerte K$_A$ und K$_E$. Mit einer Krümmung K$_A$ von 50 km$^{-1}$ und einer Krümmung K$_E$: von 70 km$^{-1}$ gilt hier K$_A$-K$_E$<0, d.h. die GaN-Schicht ist bei Wachstumstemperatur intrinsisch tensil verspannt. Durch eine Abkühlung wird dieser Verspannung der GaN-Schicht eine extrinsisch kompressive Verspannung überlagert.

**Patentansprüche**

**1.** Verfahren zur Herstellung eines Templats, welches ein Substrat und mindestens eine III-N-Kristallschicht umfasst, wobei III mindestens ein Element der dritten Hauptgruppe des Periodensystems, ausgewählt aus Al, Ga und In,

bedeutet, wobei das Verfahren die Schritte Bereitstellen eines Fremdsubstrats, das Saphir umfasst, und Wachstum eines kristallinen III-N-Materials auf dem Substrat umfasst,

wobei ein Maskenmaterial als Zwischenschicht im kristallinen III-N-Material in einem Abstand vom Fremdsubstrat, welches gegebenenfalls eine III-N-Nukleationsschicht aufweist, abgeschieden wird und danach das Wachstum des kristallinen III-N-Materials fortgesetzt wird und das Maskenmaterial bei der Herstellung des Templats innerhalb der III-N-Schicht des Templats *in situ* in demselben Reaktor abgeschieden wird ,wobei der Abstand der Zwischenschicht des Maskenmaterials gegenüber dem Fremdsubstrat bzw. der gegebenenfalls darauf gebildeten III-N-Nukleationsschicht maximal 50 nm beträgt,

wobei während des Kristallwachstums eine Krümmungsdifferenz $K_a - K_e \geq 0$ eingestellt wird, wobei die Krümmung der Wachstumsoberfläche des III-N-Kristalls zu einem ersten, relativ früheren Zeitpunkt mit $K_a$ und zu einem zweiten relativ späteren Zeitpunkt mit $K_e$ bezeichnet wird.

2. Verfahren gemäß Anspruch 1, **dadurch gekennzeichnet, dass** die Krümmungsdifferenz $(K_a - K_e)$ mindestens 5 $km^{-1}$, bevorzugt mindestens 10 $km^{-1}$, weiter bevorzugt mindestens 20 $km^{-1}$ und insbesondere mindestens 50 $km^{-1}$ beträgt.

3. Verfahren gemäß Anspruch 1 oder 2, wobei das Templat weiterverwendet wird zum Aufbringen von einer oder mehreren weiteren III-N-Kristalischicht(en), wahlweise zum Herstellen von III-N-Massivkristall, wobei die III-N-Kristallschicht(en) oder der III-N-Massivkristall epitaxial gewachsene GaN-, AlN-, AlGaN-, InN-, InGaN-, AlInN- oder AlInGaN-Kristalle umfasst.

4. Verfahren gemäß Anspruch 1 zur Herstellung eines III-N-Einkristalls, zusätzlich die folgenden Schritte aufweisend:

Durchführen eines epitaxialen Kristallwachstums zum Bilden von weiterem III-N-Kristall, wahlweise zum Herstellen von III-N-Massivkristall auf dem Templat, und

optional Trennen von III-N-Einkristall oder III-N-Massivkristall und Fremdsubstrat.

5. Verfahren gemäß Anspruch 4, wobei im bereitgestellten Templat im Bereich über dem Startsubstrat in der III-N-Kristallschicht des Templats ein Maskenmaterial als Zwischenschicht derart abgeschieden ist, dass ein Abstand der Zwischenschicht des Maskenmaterials gegenüber dem Fremdsubstrat oder der gegebenenfalls darauf gebildeten III-N-Nukleationsschicht maximal 50 nm beträgt, wobei vorzugsweise das Maskenmaterial bei der Herstellung des Templats innerhalb der III-N-Schicht des Templats *in situ* in demselben Reaktor abgeschieden wird und unmittelbar nach Abscheidung des Maskenmaterials mit dem III-N-Wachstumsprozess fortgesetzt wird.

6. Verfahren gemäß einem der vorangehenden Ansprüche, **dadurch gekennzeichnet, dass** wenn für das Templat als Substrat Saphir einer Dicke ($d_{Saphir}$) von ungefähr $430\mu m$ (d.h. $\pm 20\mu m$) und als III-N-Kristallschicht des GaN einer Dicke ($d_{GaN}$) von ungefähr 7 $\mu m$ (d.h. $\pm 0{,}5\mu m$) verwendet oder eingestellt wird, beim III-N-Kristall eine Krümmung des Templats ($K_T$) an der Wachstumsoberfläche

(i) bei Wachstumstemperatur im Bereich von 0 bis -150 $km^{-1}$, bevorzugt im Bereich von -25 bis -75 $km^{-1}$ festgelegt wird, und/oder

(ii) bei Raumtemperatur im Bereich von <-200 $km^{-1}$, vorzugsweise -200 bis -400 $km^{-1}$, weiter bevorzugt im Bereich von -300 bis -350 $km^{-1}$ festgelegt wird;

wobei bei Verwendung oder Einstellung anderer Schichtdicken ($d_{Saphir}/d_{GaN}$) der Krümmungswert in Abhängigkeit der jeweiligen Schichtdicken analog der Stoney-Gleichung im folgenden Bereich liegt sofern der Film ($d_{GaN}$) wesentlich dünner ist als das Substrat ($d_{Substrat}$) und $\varepsilon_{xx}$ als konstant angenommen wird:

$K_{T(dGaN;dSaphir)} = K_{T(7\mu m;430\mu m)} \times (430\mu m/d_{Saphir})^2 \times (d_{GaN}/7\mu m)$, und/oder wobei im kristallinen III-N-Material eine kompressive Verspannung erzeugt wird, vorzugsweise der III-N-Einkristall des Templats bei Raumtemperatur eine kompressive Spannung von $\sigma_{xx} < -0{,}70$ GPa aufweist, wobei $\varepsilon_{xx}$ mit Hilfe einer Röntgenmessung der absoluten Gitterkonstante bestimmt wird.

7. Verfahren gemäß einem der vorangehenden Ansprüche, wobei die Zwischenschicht des Maskenmaterials bei einem eingestellten maximalen Abstand vom Substrat, bzw. der gegebenenfalls darauf gebildeten III-N-Nukleationsschicht, bis maximal 50nm, abgeschieden wird, und/oder wobei das Maskenmaterial ein Material ist, auf dem eine III-N-Abscheidung gehemmt oder verhindert ist, bevorzugt das Maskenmaterial ausgewählt ist aus der Gruppe, die aus $Si_xN_y$, und insbesondere $Si_3N_4$, TiN, $Al_xO_Y$ und insbesondere $Al_2O_3$, $Si_xO_Y$ und insbesondere $SiO_2$, WSi, und WSiN besteht, wobei x und y jeweils unabhängig voneinander positive Zahlen bedeuten, die zu jeweiligen stöchiometrischen oder unstöchiometrischen Verbindungen von SiN, AlO bzw. SiO führen.

8. Verfahren gemäß einem der vorangehenden Ansprüche, **dadurch gekennzeichnet, dass** das Substrat aus Saphir besteht.

9. Verfahren gemäß einem der vorangehenden Ansprüche, **dadurch gekennzeichnet, dass** die Krümmung des III-N-Kristalls des Templats in mindestens einer Wachstumsphase zusätzlich dadurch verändert wird, dass eine Abscheidung bei einer gegenüber einer vorherigen Abscheidungsphase von III-N-Material der Templats abgesenkten Wachstumstemperatur erfolgt.

10. Verfahren zur Herstellung von III-N-Kristallwafern, wobei III mindestens ein Element der dritten Hauptgruppe des Periodensystems ausgesucht aus der Gruppe von Al, Ga und In bedeutet, wobei das Verfahren die folgenden Schritte umfasst:

   a) Durchführung eines Verfahrens gemäß einem der Ansprüche 3 bis 9 zum Bilden eines III-N-Massivkristalls, und

   b) Vereinzeln des Massivkristalls zum Bilden von Wafern.

11. Templat mit einem Saphir umfassenden Substrat und mindestens einer III-N-Kristallschicht, wobei III mindestens ein Element der dritten Hauptgruppe des Periodensystems, ausgewählt aus der Gruppe von Al, Ga und In, bedeutet, wobei im Bereich über dem Fremdsubstrat in der III-N-Kristallschicht des Templats ein Maskenmaterial als Zwischenschicht vorgesehen ist, wobei die III-N-Kristallschicht des Templats durch einen oder beide der folgenden Werte (i)/(ii) der Deformation $\varepsilon_{xx}$ definiert ist:

   (i) bei Raumtemperatur liegt der $\varepsilon_{xx}$-Wert im Bereich < 0, (ii) bei Wachstumstemperatur liegt der $\varepsilon_{xx}$-Wert im Bereich $\varepsilon_{xx} \leq 0$,

   wobei $\varepsilon_{xx}$ mit Hilfe einer Röntgenmessung der absoluten Gitterkonstante bestimmt ist,
   wobei ein Abstand der Zwischenschicht des Maskenmaterials gegenüber dem Substrat bzw. der gegebenenfalls darauf gebildeten III-N-Nukleationsschicht maximal 50 nm beträgt.

12. Templat gemäß Anspruch 11, wobei wenn für das Templat als Substrat Saphir einer Dicke ($d_{Saphir}$) von ungefähr $430\mu m$ (d.h. $\pm 20\mu m$) und als III-N-Kristallschicht des GaN einer Dicke ($d_{GaN}$) von ungefähr $7\mu m$ (d.h. $\pm 0,5\mu m$) verwendet oder eingestellt wird, wobei $\varepsilon_{xx}$ mit Hilfe einer Röntgenmessung der absoluten Gitterkonstante bestimmt ist,
   beim III-N-Kristall eine Krümmung des Templats ($K_T$)

   (i) bei Wachstumstemperatur im Bereich von 0 bis -150 km$^{-1}$, bevorzugt im Bereich von -25 bis -75 km$^{-1}$ festgelegt ist; und/oder
   (ii) bei Raumtemperatur im Bereich von -200 bis -400 km$^{-1}$, bevorzugt im Bereich von -300 bis -400 km$^{-1}$ festgelegt ist, wobei eine negative Krümmung eine konvexe Krümmung ist,

   wobei bei Verwendung oder Einstellung anderer Schichtdicken ($d_{Saphir}/d_{GaN}$) der Krümmungswert in Abhängigkeit der jeweiligen Schichtdicken analog der Stoney-Gleichung im folgenden Bereich liegt sofern der Film ($d_{GaN}$) wesentlich dünner ist als das Substrat ($d_{Substrat}$) und $\varepsilon_{xx}$ als konstant angenommen wird:

$$K_{T(dGaN;dSaphir)} = K_{T(7\mu m;430\mu m)} \times (430\mu m/d_{Saphir})^2 \times (d_{GaN}/7\mu m).$$

13. Verwendung eines Templats gemäß einem der Ansprüche 11 bis 12 zur Herstellung von dickeren III-N-Schichten oder III-N-Kristallboules bzw. -Massivkristallen, die optional danach in einzelne III-N-Wafer vereinzelt werden, oder Verwendung eines Templats gemäß einem der Ansprüche 11 bis 12, jeweils zur Herstellung von Halbleiterbauelementen, elektronischen oder optoelektronischen Bauelementen.

14. Verwendung eines Maskenmaterials als Zwischenschicht in einem Templat, welches ein Saphir umfassendes Substrat und eine III-N-Kristallschicht aufweist, wobei III mindestens ein Element der dritten Hauptgruppe des Periodensystems, ausgewählt aus der Gruppe von Al, Ga und In, bedeutet, zum Steuern eines Krümmungswerts und/oder einer Verspannung des Templats, um nach Einstellung eines bestimmten Krümmungswerts und/oder einer bestimmten Verspannung mindestens eine weitere III-N-Kristallschicht auf dem Substrat aufzubringen, wobei ein Abstand der Zwischenschicht des Maskenmaterials gegenüber dem Substrat bzw. der gegebenenfalls darauf gebildeten III-N-Nukleationsschicht vorliegt und maximal 50 nm beträgt.

15. Verfahren zur Herstellung von Halbleiterbauelementen, elektronischen oder optoelektronischen Bauelementen, in dem das Verfahren zur Herstellung von III-N-Kristallwafern nach Anspruch 10 durchgeführt wird.

**Claims**

1. A process for preparing a template comprising a substrate and at least one III-N crystal layer, wherein III denotes at least one element of the main group III of the periodic table of the elements, selected from Al, Ga and In, wherein the process comprises the steps of
providing a foreign substrate comprising sapphire, and growing a crystalline III-N material on the substrate, wherein a mask material is deposited as interlayer in the crystalline III-N material at a distance from the foreign substrate, which optionally exhibits a III-N nucleation layer, and subsequently the growth of a crystalline III-N material is continued, and wherein the mask material is deposited *in situ* in the same reactor during the preparation of the template within the III-N-layer of the template, wherein the distance of the interlayer of the mask material to the foreign substrate or respectively the III-N nucleation layer optionally formed thereon is at most 50 nm, wherein during the crystal growth a curvature difference of $K_a - K_e \geq 0$ is adjusted, wherein the curvature of the growth surface of the III-N crystal at a first, relatively earlier time point is denoted as $K_a$ and at a second, relatively later time point is denoted as $K_e$.

2. The process according to claim 1, **characterized in that** the curvature difference ($K_a - K_e$) is at least 5 km$^{-1}$, preferably at least 10 km$^{-1}$, more preferably at least 20 km$^{-1}$ and in particular at least 50 km$^{-1}$.

3. The process according to claim 1 or 2, wherein the template is further used for depositing one or multiple further III-N crystal layer(s), optionally for producing III-N bulk crystal, wherein the III-N crystal layer(s) or the III-N bulk crystal comprises epitaxially grown GaN, AlN, AlGaN, InN, InGaN, AlInN or AlInGaN crystals.

4. The process according to claim 1 for producing a III-N single crystal, wherein the process comprises the following additional steps:

   carrying out an epitaxial crystal growth for forming further III-N crystal, optionally for producing III-N bulk crystal on the template, and
   optionally separating III-N single crystal or III-N bulk crystal and foreign substrate.

5. The process according to claim 4, wherein a mask material is deposited as interlayer in the provided template in the region above the starting substrate in the III-N crystal layer of the template, such that a distance of the interlayer of the mask material to the foreign substrate or respectively the III-N nucleation layer optionally formed thereon is at most 50 nm, wherein preferably the mask material is deposited in situ in the same reactor during the preparation of the template, and the III-N- growth process is continued directly after the deposition of the mask material.

6. The process according to one of the preceding claims, **characterized in that** when for the template as substrate sapphire with a thickness ($d_{sapphire}$) of approximately 430 $\mu$m (i.e. $\pm 20$ $\mu$m) and as III-N crystal layer GaN with a thickness ($d_{GaN}$) of approximately 7 $\mu$m (i.e. $\pm 0.5$ $\mu$m) is used or set, the III-N crystal a curvature of the template ($K_T$) at the growth surface

   (i) at growth temperature is specified in the range from 0 to -150 km$^{-1}$, preferably in the range from -25 to -75 km$^{-1}$, and/or
   (ii) at room temperature is specified in the range of < -200 km$^{-1}$, preferably from -200 to -400 km$^{-1}$, more preferably in the range from -300 to -350 km$^{-1}$;

wherein when using or setting different layer thicknesses ($d_{sapphire}/d_{GaN}$) the curvature value lies depending on the respective layer thicknesses analogous to the Stoney equation in the following range:

$$K_{T(dGaN;dsapphire)} = K_{T(7\mu m;430\mu m)} \times (430\mu m / d_{sapphire})^2 \times (d_{GaN}/7\mu m),$$

if the film $d_{GaN}$ is substantially thinner compared to the substrate and $\varepsilon_{xx}$ is considered as constant, and/or wherein a compressive stress is produced within the III-N-material, and preferably the III-N single crystal of the template exhibits a compressive stress $\sigma_{xx}$ of < -0.70 GPa at room temperature, wherein $\varepsilon_{xx}$ is determined by an X-ray measurement of the absolute lattice constant.

7. The process according to one of the preceding claims, wherein the interlayer of the mask material is deposited at a set maximum distance from the substrate, or respectively from the III-N nucleation layer optionally formed thereon, of maximally 50 nm, and/or wherein the mask material is a material on which a III-N deposition is inhibited or prevented, preferably the mask material is selected from the group consisting of $Si_xN_y$ and in particular $Si_3N_4$, TiN, $Al_xO_Y$ and in particular $Al_2O_3$, $Si_xO_Y$ and in particular $SiO_2$, WSi, and WSiN, wherein x and y respectively independently from each other denote positive numbers which lead to respective stoichiometric or non-stoichiometric compounds of SiN, AlO and SiO, respectively.

8. The process according to one of the preceding claims, **characterized in that** the substrate consists of sapphire.

9. The process according to one of the preceding claims, **characterized in that** the curvature of the III-N crystal of the template is additionally changed in at least one growth phase by carrying out a deposition at a lowered growth temperature compared to that of a preceding deposition stage of III-N material of the template.

10. A process for preparing III-N crystal wafers, wherein III denotes at least one element of the main group III of the periodic table of the elements, selected from the group of Al, Ga and In, wherein the process comprises the following steps:

   a) carrying out a process according to one of the claims 3 to 9 for forming a III-N bulk crystal, and
   b) separating of the bulk crystal for forming wafers.

11. A template with a substrate comprising sapphire and at least one III-N crystal layer, wherein III denotes at least one element of the main group III of the periodic table of the elements, selected from the group of Al, Ga and In, wherein in the region above the foreign substrate in the III-N crystal layer of the template a mask material is provided as interlayer, wherein the III-N crystal layer of the template is defined by one or both of the following values (i)/(ii) of the deformation $\varepsilon_{xx}$:

   (i) at room temperature the $\varepsilon_{xx}$ value lies in the range of <0,
   (ii) at growth temperature the $\varepsilon_{xx}$ value lies in the range of $\varepsilon_{xx} \leq 0$,

   wherein $\varepsilon_{xx}$ is determined by an X-ray measurement of the absolute lattice constant, wherein the distance of the interlayer of the mask material to the foreign substrate or respectively the III-N nucleation layer optionally formed thereon is at most 50 nm.

12. The template according to claim 11, wherein, if for the template as substrate sapphire with a thickness ($d_{sapphire}$) of approximately 430 $\mu$m (i.e. $\pm 20$ $\mu$m) and as III-N crystal layer of GaN with a thickness ($d_{GaN}$) of approximately 7 $\mu$m (i.e. $\pm 0.5$ $\mu$m) is used or set, wherein $\varepsilon_{xx}$ is determined by an X-ray measurement of the absolute lattice constant, the III-N crystal a curvature of the template ($K_T$)

   (i) at growth temperature is specified in the range from 0 to -150 km$^{-1}$, preferably in the range from -25 to -75 km$^{-1}$; and/or
   (ii) at room temperature is specified in the range from -200 to -400 km$^{-1}$, preferably in the range from -300 to -400 km$^{-1}$,

   wherein a negative curvature is a convex curvature, wherein when using or setting other layer thicknesses ($d_{sapphire}/d_{GaN}$), the curvature value lies in the following range depending on the respective layer thicknesses analogous to the Stoney equation:

$$K_{T(dGaN;dsapphire)} = K_{T(7\mu m;430\mu m)} \times (430\mu m / d_{sapphire})^2 \times (d_{GaN}/7\mu m),$$

if the film ($d_{GaN}$) is substantially thinner compared to the substrate ($d_{sapphire}$), and $\varepsilon_{xx}$ is assumed to be constant.

13. Use of a template according to one of the claims 11 or 12 for producing thicker III-N layers or III-N crystal boules or respectively III-N bulk crystals, which optionally thereafter are separated into individual III-N wafers, or use of a template according to one of the claims 11 to 12 respectively for producing semiconductor devices, electronic or opto-electronic devices.

14. Use of a mask material as interlayer in a template which exhibits a substrate comprising sapphire and a III-N crystal layer, wherein III denotes at least one element of the main group III of the periodic table of the elements, selected from the group of Al, Ga and In, for controlling a curvature value and/or a stress of the template to deposit at least one further III-N crystal layer on the substrate after setting of a particular curvature value and/or a particular stress, wherein a distance of the interlayer of the mask material to the foreign substrate or respectively the III-N nucleation layer optionally formed thereon is present and is at most 50 nm.

15. Process for the production of semiconductor devices, electronic or opto-electronic devices, for which the process for the production of III-N crystal wafers according to claim 10 is carried out.

**Revendications**

1. Procédé de production d'une matrice comprenant un substrat et au moins une couche cristalline III-N, dans lequel III représente au moins un élément du troisième groupe principal du système périodique, sélectionné parmi Al, Ga et In, dans lequel le procédé comprend les étapes suivantes :

préparation d'un substrat étranger comprenant du saphir, et
croissance d'une matière cristalline III-N sur le substrat,
dans lequel une matière de masque est déposée à espacement du substrat étranger en tant que couche intercalaire dans la matière cristalline III-N, laquelle présente le cas échéant une couche de nucléation III-N et la croissance de la matière cristalline III-N est ensuite poursuivie et la matière de masque est déposée lors de la production de la matrice à l'intérieur de la couche III-N de la matrice *in situ* dans le même réacteur, dans lequel l'espacement entre la couche intercalaire de matière de masque et le substrat étranger ou la couche de nucléation III-N éventuellement formée sur celui-ci est de 50 nm au maximum,
dans lequel une différence de courbure $K_a$-$K_e \geq 0$ est ajustée pendant la croissance cristalline, dans lequel la courbure de la surface de croissance du cristal III-N est désignée par $K_a$ à un premier moment relativement précoce et par $K_e$ à un deuxième moment relativement tardif.

2. Procédé selon la revendication 1, **caractérisé en ce que** la différence de courbure ($K_a$-$K_e$) est d'au moins 5 km$^{-1}$, avantageusement au moins 10 km$^{-1}$, préférentiellement d'au moins 20 km$^{-1}$ et tout particulièrement d'au moins 50 km$^{-1}$.

3. Procédé selon la revendication 1 ou 2, dans lequel la matrice est réutilisée pour l'application d'une ou de plusieurs autres couches cristallines III-N, sélectivement pour la production de cristal massif III-N, dans lequel la ou les couche(s) cristalline(s) III-N ou le cristal massif III-N comprend des cristaux GaN, AlN, AlGaN, InN, InGaN, AlInN ou AlInGaN à croissance épitaxiale.

4. Procédé selon la revendication 1 pour la production d'un monocristal III-N, comprenant en outre les étapes suivantes :

exécution d'une croissance cristalline épitaxiale pour former un autre cristal III-N, sélectivement pour la production de cristal massif III-N sur la matrice, et
séparation facultative du monocristal III-N ou du cristal massif III-N et du substrat étranger.

5. Procédé selon la revendication 4, dans lequel, dans la matrice préparée, une matière de masque est déposée comme couche intercalaire dans la région sur le substrat initial dans la couche cristalline III-N de la matrice, de telle manière qu'un espacement entre la couche intercalaire de matière de masque et le substrat étranger ou la couche de nucléation III-N éventuellement formée sur celui-ci est de 50 nm au maximum, dans lequel la matière de masque est préférentiellement déposée lors de la production de la matrice à l'intérieur de la couche III-N de la matrice *in situ* dans le même réacteur, et le processus de croissance III-N est poursuivi immédiatement après dépôt de la matière de masque.

**6.** Procédé selon l'une des revendications précédentes, **caractérisé en ce que** si, pour la matrice, du saphir ayant une épaisseur ($d_{Saphir}$) d'environ 430 $\mu$m (soit $\pm20$ $\mu$m) est utilisé ou ajusté comme substrat et du GaN ayant une épaisseur ($d_{GaN}$) d'environ 7 $\mu$m (soit $\pm0,5$ $\mu$m) est utilisé ou ajusté comme couche cristalline III-N, pour le cristal III-N une courbure de la matrice ($K_T$) sur la surface de croissance

(i) est définie entre 0 et 150 km$^{-1}$ à température de croissance, avantageusement entre -25 et -75 km$^{-1}$, et/ou
(ii) est définie dans la plage < -200 km$^{-1}$ à température ambiante, avantageusement entre -200 et -400 km$^{-1}$, préférentiellement entre -300 et 350 km$^{-1}$ ;

dans lequel, en cas d'utilisation ou d'ajustement d'autres épaisseurs de couche ($d_{Saphir}/d_{GaN}$), la valeur de courbure est comprise dans la plage suivante en fonction des épaisseurs de couche respectives de manière analogue à l'équation de Stoney, si le film ($d_{GaN}$) est sensiblement plus mince que le substrat ($d_{Substrat}$) et $\varepsilon_{xx}$ est supposée constante :

$K_{T\ (dGaN;dsaphir)}=K_{T\ (7\mu m;430\mu m)}$ x $(430\mu m/_{dSaphir})^2$ x $(d_{GaN}/7\mu m)$, et/ou dans lequel une contrainte de compression est générée dans la matière cristalline III-N, le monocristal III-N de la matrice présentant préférentiellement une contrainte de compression de $\sigma_{xx}$ <-0,70 GPa à température ambiante, dans lequel $\varepsilon_{xx}$ est déterminée au moyen d'une mesure par rayons X de la constante de réseau absolue.

**7.** Procédé selon l'une des revendications précédentes, dans lequel la couche intercalaire de matière de masque est déposée avec un espacement maximal ajusté de 50 nm au substrat, ou à la couche de nucléation III-N éventuellement formée sur celui-ci, et/ou dans lequel la matière de masque est une matière sur laquelle un dépôt III-N est inhibé ou empêché, la matière de masque étant avantageusement sélectionné dans le groupe composé de $Si_xN_y$, et en particulier $Si_3N_4$, de TiN, d'$Al_xO_Y$ et en particulier $Al_2O_3$, de $Si_xO_Y$ et en particulier $SiO_2$, WSi et WSiN, où x et y représentent chacun indépendamment de l'autre des nombres positifs, menant aux composés stoechiométriques ou non stoechiométriques de SiN, AlO ou SiO.

**8.** Procédé selon l'une des revendications précédentes, **caractérisé en ce que** le substrat est en saphir.

**9.** Procédé selon l'une des revendications précédentes, **caractérisé en ce que** la courbure du cristal III-N de la matrice est en outre modifiée pendant au moins une phase de croissance, par dépôt effectué avec une température de croissance abaissée par rapport à une phase de dépôt précédente de la matière III-N de la matrice.

**10.** Procédé de production de tranches en cristal III-N, dans lequel III représente au moins un élément du troisième groupe principal du système périodique sélectionné dans le groupe composé de Al, Ga et In, dans lequel le procédé comprend les étapes suivantes :

a) exécution d'un procédé selon l'une des revendications 3 à 9 pour former un cristal massif III-N, et
b) séparation du cristal massif pour former des tranches.

**11.** Matrice avec un substrat comprenant du saphir et au moins une couche cristalline III-N, dans laquelle III représente au moins un élément du troisième groupe principal du système périodique, sélectionné parmi Al, Ga et In, dans laquelle une matière de masque est prévue comme couche intercalaire dans la région sur le substrat étranger dans la couche cristalline III-N de la matrice, dans laquelle la couche cristalline III-N de la matrice est définie par une, ou par les deux valeurs suivantes (i)/(ii) de déformation $\varepsilon_{xx}$:

(i) à température ambiante, la valeur $\varepsilon_{xx}$ est dans < 0, (ii) à température de croissance, la valeur $\varepsilon_{xx}$ est $\leq 0$,

dans laquelle $\varepsilon_{xx}$ est déterminée au moyen d'une mesure par rayons X de la constante de réseau absolue, dans laquelle un espacement entre la couche intercalaire de matière de masque et le substrat ou la couche de nucléation III-N éventuellement formée sur celui-ci est de 50 nm au maximum.

**12.** Matrice selon la revendication 11, dans laquelle si, pour la matrice, du saphir ayant une épaisseur ($d_{Saphir}$) d'environ 430 $\mu$m (soit $\pm20$ $\mu$m) est utilisé ou ajusté comme substrat et du GaN ayant une épaisseur ($d_{GaN}$) d'environ 7 $\mu$m (soit $\pm0,5$ $\mu$m) est utilisé ou ajusté comme couche cristalline III-N, dans laquelle $\varepsilon_{xx}$ est déterminée au moyen d'une mesure par rayons X de la constante de réseau absolue, pour le cristal III-N une courbure de la matrice ($K_T$)

(i) est définie entre 0 et 150 km$^{-1}$ à température de croissance, avantageusement entre -25 et -75 km$^{-1}$, et/ou
(ii) est définie dans la plage entre -200 km$^{-1}$ et -400 km$^{-1}$ à température ambiante, avantageusement entre -300 et -400 km$^{-1}$, une courbure négative étant une courbure convexe,

dans laquelle, en cas d'utilisation ou d'ajustement d'autres épaisseurs de couche (d$_{Saphir/dGaN}$), la valeur de courbure est comprise dans la plage suivante en fonction des épaisseurs de couche respectives de manière analogue à l'équation de Stoney, si le film (d$_{GaN}$) est sensiblement plus mince que le substrat (d$_{Substrat}$) et $\varepsilon_{xx}$ est supposée constante :

$$K_{T\,(dGaN;dsaphir)}=K_{T\,(7\mu m;430\mu m)} \times (430\mu m/d_{Saphir})^2 \times (d_{GaN}/7\mu m).$$

**13.** Utilisation d'une matrice selon l'une des revendications 11 à 12 pour la production de couches III-N épaisses ou de boules de cristal III-N ou de cristaux massifs III-N, optionnellement séparés ensuite en tranches III-N individuelles, ou utilisation d'une matrice selon l'une des revendications 11 à 12 pour la production de composants semi-conducteurs, de composants électroniques ou optoélectroniques.

**14.** Utilisation d'une matière de masque comme couche intercalaire dans une matrice présentant un substrat comprenant du saphir et une couche cristalline III-N, dans laquelle III représente au moins un élément du troisième groupe principal du système périodique, sélectionné dans le groupe composé de Al, Ga et In, pour la commande d'une valeur de courbure et/ou d'une contrainte de la matrice, pour l'application d'au moins une autre couche cristalline III-N sur le substrat après ajustement d'une valeur de courbure définie et/ou d'une contrainte définie, dans laquelle un espacement est présenté entre la couche intercalaire de matière de masque et le substrat étranger ou la couche de nucléation III-N éventuellement formée sur celui-ci et est de 50 nm au maximum.

**15.** Procédé de production de composants semi-conducteurs, de composants électroniques ou optoélectroniques, dans lequel est exécuté le procédé de production de tranches de cristal III-N selon la revendication 10.

# FIG.1 A

# FIG.1 B

(1)

100 A

100 B

(2)

101 A
100 A

101 B
100 B

(3)

102 A
101 A
100 A

102 B
103 B
100 B

(4)

104 A
102 A
103 A
100 A

104 B
102 B
100 B
103 B

(5)

105 A
102 A
100 A

105 B
102 B
100 B

(6)

105 A
102 A
100 A

105 B
102 B
100 B

Fig. 2

Fig. 3

Wafertemperatur, Prozesstemperatur

Fig. 4

Fig. 5A

Fig. 5B

Fig. 5C

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080217645 A1
- WO 2012035135 A1
- DE 102006008929 A1
- US 20090092815 A1
- EP 1501117 A1
- WO 2007068756 A1
- US 20030232457 A1
- WO 2006035212 A1
- WO 2008096168 A1
- WO 2008087452 A1
- EP 2136390 A2
- WO 2007107757 A2
- DE 102005023302 A1
- EP 000002299236 A1

**In der Beschreibung aufgeführte Nicht-Patentliteratur**

- **HEARNE et al.** *Applied Physics Letters,* 1999, vol. 74, 356-358
- **TANAKA et al.** *Jpn. J. Appl. Phys.,* 2000, vol. 39, L831-L834
- *Journal of Crystal Growth,* 2006, vol. 289, 445-449
- **BRÜCHEN. RICHTER ; E. RICHTER ; U.ZEIMER ; S.HAGEDORN ; M.WAGNER ; F.BRUNNER ; M.WEYERS ; G.TRÄNKLE et al.** *Journal of Crystal Growth,* 2010, vol. 312, 2537
- *Journal of Crystal Growth,* 2007, vol. 298, 202-206
- **E. RICHTER ; M. GRÜNDER ; B. SCHINELLER ; F. BRUNNER ; U. ZEIMER ; C. NETZEL ; M. WEYERS ; G. TRÄNKLE.** *Phys. Status Solidi C,* 2011, vol. 8 (5), 1450
- **HERTKORN et al.** *J. Cryst. Growth,* 2008, vol. 310, 4867-4870
- **KLEIN et al.** *Journal of Crystal Growth,* 2011, vol. 324, 63-72
- **KROST et al.** *Applied Physics Letter,* 2010, vol. 97 (18), 181105-181105
- **KROST et al.** *Journal of Crystal Growth,* 2005, vol. 275, 209-216
- **V. DARAKCHIEVA ; B. MONEMAR ; A. USUI ; M. SAENGER ; M. SCHUBERT.** *Journal of Crystal Growth,* 2008, vol. 310, 959-965
- **M. A. MORAM ; M. E. VICKERS.** *Rep. Prog. Phys.,* 2009, vol. 72, 036502
- **HEARNE et al.** *Appl.Physics Letters,* 2007, vol. 74, 356-358
- **I. AHMAD ; M. HOLTZ ; N. N. FALEEV ; H. TEMKIN.** *J. Appl. Phys.,* 2004, vol. 95, 1692
- **J. SHEN ; S. JOHNSTON ; S. SHANG ; T. ANDERSON.** *J. Cryst. Growth,* 2002, vol. 6, 240
- **BRUNNER et al.** *J. Crystal Growth,* 2007, vol. 298, 202-206